# EUROPEAN PATENT APPLICATION

(11) **EP 1 933 388 A1**
(43) Date of publication of application: **18.06.2008**
(21) Application number: 06810890.1
(22) Date of filing: 29.09.2006
(51) Int. Cl.: H01L 31/04, C23C 16/24, H01L 21/205

(54) **SILICON-BASED THIN FILM PHOTOELECTRIC CONVERTER, AND METHOD AND APPARATUS FOR MANUFACTURING SAME**

(30) Priority: 03.10.2005 JP 2005290191
(71) Applicant: Sharp Kabushiki Kaisha, Osaka-shi, Osaka 545-8522 (JP)
(72) Inventor: KISHIMOTO, Katsushi, Kyoto 619-0232 (JP)
(74) Representative: Müller - Hoffmann & Partner
(86) International application number: PCT/JP2006/319510
(87) International publication number: WO 2007/040183

(57) **Abstract**

A present method of manufacturing a silicon-based thin-film photoelectric conversion device is **characterized in that** a double pin structure stack body (30) is formed by successively forming, in an identical plasma CVD film deposition chamber, a first p-type semiconductor layer (11), an i-type amorphous silicon-based photoelectric conversion layer (12), a first n-type semiconductor layer (13), a second p-type semiconductor layer (21), an i-type microcrystalline silicon-based photoelectric conversion layer (22), and a second n-type semiconductor layer (23) on a transparent conductive film (2) formed on a substrate (1), and the first p-type semiconductor layer (11), the i-type amorphous silicon-based photoelectric conversion layer (12) and the first n-type semiconductor layer (13) are formed under such conditions that a film deposition pressure in the plasma CVD film deposition chamber is not lower than 200Pa and not higher than 3000Pa and power density per unit electrode area is not lower than 0.01W/cm² and not higher than 0.3 W/cm². Thus, the silicon-based thin-film photoelectric conversion device attaining excellent quality and high photoelectric conversion efficiency can be manufactured at-low cost and high efficiency using a simplified manufacturing apparatus.

## Description

### TECHNICAL FIELD

The present invention relates to a silicon-based thin-film photoelectric conversion device having excellent performance, and a method and an apparatus for manufacturing the same, and more particularly to a silicon-based thin-film photoelectric conversion device attaining drastically improved production cost and production efficiency, and a method and an apparatus for manufacturing the same. In the subject application, the terms "polycrystalline", "microcrystalline" and "crystalline" encompass a partially amorphous state.

### BACKGROUND ART

In recent years, development and increased production of solar batteries including, for example, a thin film containing crystalline silicon such as polycrystalline silicon or microcrystalline silicon have attracted worldwide attention. A great characteristic of the solar batteries resides in that a semiconductor film or a metal electrode film is deposited on an inexpensive large-area substrate using a film deposition apparatus such as a plasma CVD apparatus or a sputtering apparatus, and thereafter solar battery cells fabricated on the identical substrate are isolated and connected by using a method such as laser patterning, so that lower cost and higher performance of the solar batteries can both be achieved. In such a manufacturing process, increase in manufacturing cost of the solar batteries due to higher cost of a manufacturing apparatus represented by a CVD apparatus which is a main apparatus for fabricating devices has become one of the bottlenecks in widespread use.

Conventionally, in an apparatus for producing solar batteries, an in-line system in which a plurality of film deposition chambers (also referred to as chamber hereinafter) are linearly connected or a multi-chamber system in which an intermediate chamber is provided in the center and a plurality of film deposition chambers are arranged around the same has been adopted. In the in-line system, however, a flow line for transferring the substrate is linear and the entire apparatus should be stopped when maintenance is required only in part. For example, as a plurality of film deposition chambers for forming an i-type silicon photoelectric conversion layer that require maintenance most are included, the entire production line is disadvantageously stopped even when a single film deposition chamber for forming an i-type silicon photoelectric conversion layer requires maintenance.

On the other hand, the multi-chamber system is a system in which a substrate on which a film should be formed is moved to each film deposition chamber via the intermediate chamber and a movable partition capable of maintaining hermeticity is provided between each film deposition chamber and the intermediate chamber. Accordingly, even when an unfavorable event occurs in a certain film deposition chamber, other film deposition chambers can be used and the entire production is not stopped. In the production apparatus adapted to the multi-chamber system, however, there are a plurality of flow lines of the substrate via the intermediate chamber and a mechanical structure of the intermediate chamber is inevitably complicated. For example, a mechanism for moving the substrate while maintaining hermeticity between the intermediate chamber and each film deposition chamber is complicated and expensive. In addition, the number of film deposition chambers arranged around the intermediate chamber is also restricted in terms of space.

In view of these problems, a method of manufacturing a silicon-based thin-film photoelectric conversion device, characterized in that a p-type semiconductor layer, an i-type microcrystalline silicon-based photoelectric conversion layer and an n-type semiconductor layer are successively formed in an identical plasma CVD film deposition chamber and the p-type semiconductor layer is formed under the condition that a pressure in the film deposition chamber is not lower than 667Pa (5Torr), has been proposed (for example, see Japanese Patent Laying-Open No. 2000-252495 (Patent Document 1)). According to this method, a photoelectric conversion device having excellent performance and quality can be manufactured at low cost and high efficiency using a simplified apparatus.

This manufacturing method is disadvantageous, however, in that, due to repeated formation of the p-type semiconductor layer, the i-type silicon-based photoelectric conversion layer and the n-type semiconductor layer (hereinafter also referred to as a "pin layer"; in addition, a structure in which the p-type layer, the i-type layer and the n-type layer are arranged in this order is also referred to as a "pin structure") in the identical film deposition chamber with this method in order to improve productivity that is aimed at, an n-type dopant in the n-type layer in a remaining film formed on a cathode and/or an inner surface in the plasma CVD film deposition chamber is inevitably introduced into a next p-type semiconductor layer and an i-type silicon-based photoelectric conversion layer at an initial stage of forming the next p-type semiconductor layer and the i-type silicon-based photoelectric conversion layer.

Specifically, in the plasma CVD film deposition chamber, initially, the p-type layer is formed on the cathode and/or the inner surface in the film deposition chamber in forming the p-type semiconductor layer, the i-type layer is then formed on the p-type layer in forming the i-type silicon-based photoelectric conversion layer, and the n-type layer is then formed on the i-type layer in forming the n-type semiconductor layer. A stacked film of the p-type layer, the i-type layer and the n-type layer is thus formed as the remaining film on the cathode and/or the inner surface in the plasma CVD film deposition chamber. The n-type dopant (also referred to as n-type impurity atom hereinafter) in the n-type layer in such a remaining film is disadvantageously introduced into a next p semiconductor layer and an i-type silicon-based photoelectric conversion layer at the initial stage of forming the next p-type semiconductor layer and the i-type silicon-based photoelectric conversion layer.

Here, influence of the n-type dopant on the p-type semiconductor layer is such that the n-type dopant weakens the action of a p-type dopant (also referred to as p-type impurity atom hereinafter) and therefore, space charge of the p-type semiconductor layer necessary for fabricating solar batteries cannot be ensured. Then, even when conventionally satisfactory conditions for manufacturing the p-type semiconductor layer are employed, parameters of the solar batteries are adversely affected; for example, an open-circuit voltage or a polar factor is lowered. In addition, influence of the n-type dopant on the i-type silicon-based photoelectric conversion layer has also been known. Specifically, diffusion of the n-type dopant in the remaining film into the i-type silicon-based photoelectric conversion layer increases recombination level in the i-type silicon-based photoelectric conversion layer and weakens internal electric field, which results in significant lowering in short-wavelength sensitivity of the solar batteries (for example, see Japanese Patent Laying-Open No. 2000-243993 (Patent Document 2)).

In addition, as a method of manufacturing a silicon-based photoelectric conversion device by stacking a plurality of pin layers, a method of fabricating an amorphous photoelectric conversion layer in an in-line system CVD apparatus and thereafter manufacturing a microcrystalline silicon-based photoelectric conversion layer in another CVD apparatus has also been proposed (see, for example, Japanese Patent Laying-Open No. 2000-252496 (Patent Document 3)). This is because characteristics are lowered if the amorphous photoelectric conversion layer is formed in the identical film deposition chamber, and this method aims to make the line more efficient by manufacturing the amorphous photoelectric conversion layer and the microcrystalline silicon-based photoelectric conversion layer, that are mutually exclusive in terms of apparatus tact, in different CVD apparatuses. Moreover, the method is also effective in reducing down time, which is a problem in the CVD apparatus adapted to the in-line system.

All of the manufacturing methods above, however, require a complicated manufacturing apparatus and maintenance, and therefore, development of a method allowing manufacturing of a photoelectric conversion device with excellent characteristics at low cost and high efficiency by using a simplified manufacturing apparatus has been demanded.
Patent Document 1: Japanese Patent Laying-Open No. 2000-252495
Patent Document 2: Japanese Patent Laying-Open No. 2000-243993
Patent Document 3: Japanese Patent Laying-Open No. 2000-252496

### DISCLOSURE OF THE INVENTION

### PROBLEMS TO BE SOLVED BY THE INVENTION

An object of the present invention is to provide a method and an apparatus for manufacturing a silicon-based thin-film photoelectric conversion device attaining excellent quality and high photoelectric conversion efficiency at low cost and high efficiency by using a simplified manufacturing apparatus, as well as a silicon-based thin-film photoelectric conversion device with excellent characteristics manufactured with the manufacturing method and the manufacturing apparatus. In addition, it is also an object of the present invention to provide a manufacturing method and a manufacturing apparatus allowing manufacturing of a silicon-based thin-film photoelectric conversion device with high yield by repeatedly using an identical plasma CVD film deposition chamber, as well as a silicon-based thin-film photoelectric conversion device with excellent characteristics manufactured with the manufacturing method and the manufacturing apparatus.

### MEANS FOR SOLVING THE PROBLEMS

The present invention is directed to a method of manufacturing a silicon-based thin-film photoelectric conversion device characterized in that a double pin structure stack body is formed by successively forming, in an identical plasma CVD film deposition chamber, a first p-type semiconductor layer, an i-type amorphous silicon-based photoelectric conversion layer, a first n-type semiconductor layer, a second p-type semiconductor layer, an i-type microcrystalline silicon-based photoelectric conversion layer, and a second n-type semiconductor layer on a transparent conductive film formed on a substrate, and the first p-type semiconductor layer, the i-type
amorphous silicon-based photoelectric conversion layer and the first n-type semiconductor layer are formed under such conditions that a film deposition pressure in the plasma CVD film deposition chamber is not lower than 200Pa and not higher than 3000Pa and power density per unit electrode area is not lower than 0.01 W/cm² and not higher than 0.3W/cm².

In the method of manufacturing a silicon-based thin-film photoelectric conversion device according to the present invention, after the double pin structure stack body is formed, the silicon-based thin-film photoelectric conversion device including the double pin structure stack body can be carried out of the plasma CVD film deposition chamber and a remaining film on a cathode and/or an inner surface in the plasma CVD film deposition chamber can be removed.

In addition, in the method of manufacturing a silicon-based thin-film photoelectric conversion device according to the present invention, at least one crystalline pin structure stack body constituted of a p-type semiconductor layer, an i-type crystalline silicon-based photoelectric conversion layer and an n-type semiconductor layer can be stacked on the second n-type semiconductor layer of the double pin structure stack body formed with the manufacturing method described above.

In addition, the present invention is directed to a silicon-based thin-film photoelectric conversion device including a transparent conductive film formed on a substrate, and a double pin structure stack body, characterized in that the double pin structure stack body is formed of a first p-type semiconductor layer, an i-type amorphous silicon-based photoelectric conversion layer, a first n-type semiconductor layer, a second p-type semiconductor layer, an i-type microcrystalline silicon-based photoelectric conversion layer, and a second n-type semiconductor layer successively formed on the transparent conductive film, and each of the first n-type semiconductor layer and the second p-type semiconductor layer has an impurity nitrogen atom concentration not higher than 1 × 10¹⁹cm⁻³ and an impurity oxygen atom concentration not higher than 1 × 10²⁰cm⁻³.

In addition, the present invention is directed to a silicon-based thin-film photoelectric conversion device including a transparent conductive film formed on a substrate, and a double pin structure stack body, characterized in that the double pin structure stack body is formed of a first p-type semiconductor layer, an i-type amorphous silicon-based photoelectric conversion layer, a first n-type semiconductor layer, a second p-type semiconductor layer, an i-type microcrystalline silicon-based photoelectric conversion layer, and a second n-type semiconductor layer successively formed on the transparent conductive film, a concentration of impurity atom determining a conductivity type of the first n-type semiconductor layer is not higher than 3×10¹⁹cm⁻³ and a concentration of impurity atom determining a conductivity type of the second p-type semiconductor layer is not higher than 5x10¹⁹cm-3.

In addition, the present invention is directed to a method of manufacturing a silicon-based thin-film photoelectric conversion device including the step of successively forming, in an identical plasma CVD film deposition chamber, a p-type semiconductor layer, an i-type amorphous silicon-based photoelectric conversion layer, and an n-type semiconductor layer on a transparent conductive film formed on a substrate, and the p-type semiconductor layer, the i-type amorphous silicon-based photoelectric conversion layer and the n-type semiconductor layer are formed under such conditions that a film deposition pressure in the plasma CVD film deposition chamber is not lower than 200Pa and not higher than 3000Pa and power density per unit electrode area is not lower than 0.01 W/cm² and not higher than 0.3 W/cm².

In the method of manufacturing a silicon-based thin-film photoelectric conversion device according to the present invention, after the amorphous pin structure stack body is formed, the silicon-based thin-film photoelectric conversion device including the amorphous pin structure stack body can be carried out of the plasma CVD film deposition chamber and a remaining film on a cathode and/or an inner surface in the plasma CVD film deposition chamber can be removed.

In addition, the present invention is directed to a method of manufacturing a silicon-based thin-film photoelectric conversion device characterized in that a double pin structure stack body is formed by successively forming, in an identical plasma CVD film deposition chamber, a first p-type semiconductor layer, a first i-type amorphous silicon-based photoelectric conversion layer, a first n-type semiconductor layer, a second p-type semiconductor layer, a second i-type amorphous silicon-based photoelectric conversion layer, and a second n-type semiconductor layer on a transparent conductive film formed on a substrate, and the first p-type semiconductor layer, the first i-type amorphous silicon-based photoelectric conversion layer, the first n-type semiconductor layer, the second p-type semiconductor layer, the second i-type amorphous silicon-based photoelectric conversion layer, and the second n-type semiconductor layer are formed under such conditions that a film deposition pressure in the plasma CVD film deposition chamber is not lower than 200Pa and not higher than 3000Pa and power density per unit electrode area is not lower than 0.01 W/cm² and not higher than 0.3W/cm².

In the method of manufacturing a silicon-based thin-film photoelectric conversion device according to the present invention, after the double pin structure stack body is formed, the silicon-based thin-film photoelectric conversion device including the double pin structure stack body can be carried out of the plasma CVD film deposition chamber and a remaining film on a cathode and/or an inner surface in the plasma CVD film deposition chamber can be removed.

In addition, the present invention is directed to a silicon-based thin-film photoelectric conversion device manufactured with the manufacturing method described above.

In addition, the present invention is directed to an apparatus for manufacturing a silicon-based thin-film photoelectric conversion device used in the manufacturing method described above, including a plasma CVD film deposition chamber where a cathode and an anode are arranged, a gas pressure regulating portion regulating a gas pressure within the plasma CVD film deposition chamber, and an electric power supply portion supplying electric power to the cathode; a distance between the cathode and the anode being not smaller than 3mm and not larger than 20mm, and the gas pressure regulating portion being capable of controlling a gas pressure within the CVD film deposition chamber in a range from at least 200Pa to at most 3000Pa and the electric power supply portion being capable of controlling power density per unit area of the cathode in a range from at least 0.01 W/cm² to at most 0.3 W/cm².

### EFFECTS OF THE INVENTION

According to the present invention, a thin film having one or more pin structure stack body can be formed by using an identical plasma CVD film deposition chamber, and a method and an apparatus for manufacturing a silicon-based thin-film photoelectric conversion device having excellent quality and high photoelectric conversion efficiency at low cost and high efficiency by using a simplified manufacturing apparatus, as well as a silicon-based thin-film photoelectric conversion device with excellent characteristics manufactured with the manufacturing method and the manufacturing apparatus can be provided.

### BRIEF DESCRIPTION OF THE DRAWINGS

Fig. 1 is a schematic cross-sectional view showing one embodiment of a silicon-based thin-film photoelectric conversion device according to the present invention.
Fig. 2 is a schematic diagram of a plasma CVD apparatus used in the present invention.
Fig. 3 is a schematic cross-sectional view showing another embodiment of a silicon-based thin-film photoelectric conversion device according to the present invention.
Fig. 4 is a flowchart schematically showing one embodiment of a method of manufacturing the silicon-based thin-film photoelectric conversion device according to the present invention.
Fig. 5 is a schematic cross-sectional view showing yet another embodiment of a silicon-based thin-film photoelectric conversion device according to the present invention.
Fig. 6 is a schematic cross-sectional view showing yet another embodiment of a silicon-based thin-film photoelectric conversion device according to the present invention.
Fig. 7 is a schematic cross-sectional view showing one embodiment of an apparatus for manufacturing the silicon-based thin-film photoelectric conversion device according to the present invention.
Fig. 8 illustrates relation between the number of times of formation of the stack-type silicon-based thin-film photoelectric conversion device repeatedly fabricated in Example 1 and photoelectric conversion efficiency.
Fig. 9 illustrates relation between the number of times of formation of the stack-type silicon-based thin-film photoelectric conversion device repeatedly fabricated in Example 2 and photoelectric conversion efficiency.
Fig. 10 illustrates relation between the number of times of formation of the silicon-based thin-film photoelectric conversion device repeatedly fabricated in Example 3 and photoelectric conversion efficiency.
Fig. 11 illustrates relation between the number of times of formation of the stack-type silicon-based thin-film photoelectric conversion device repeatedly fabricated in Example 4 and photoelectric conversion efficiency.

### DESCRIPTION OF THE REFERENCE SIGNS

1 substrate; 2 transparent conductive film; 3 conductive film; 4 metal electrode; 10, 50 amorphous pin structure stack body; 11, 21, 41 p-type semiconductor layer; 12, 52 i-type amorphous silicon-based photoelectric conversion layer; 13, 23, 43 n-type semiconductor layer; 20 microcrystalline pin structure stack body; 22 i-type microcrystalline silicon-based photoelectric conversion layer; 30, 60 double pin structure stack body; 40 crystalline pin structure stack body; 42 i-type crystalline silicon-based photoelectric conversion layer; 100, 300, 500, 600 silicon-based thin-film photoelectric conversion device; 200 plasma CVD apparatus; 201 electric power supply portion; 205 impedance matching circuit; 206a, 206b electric power supply line; 208 electric power output portion; 210 heating chamber; 211 gas pressure regulating portion; 213 gas introduction pipe; 213v, 217v pressure regulating valve; 216 gas exhaust apparatus; 217 gas exhaust pipe; 220 film deposition chamber; 221 inner surface; 222 cathode; 223 anode; and 230 exit chamber.

### BEST MODES FOR CARRYING OUT THE INVENTION

### (Embodiment 1)

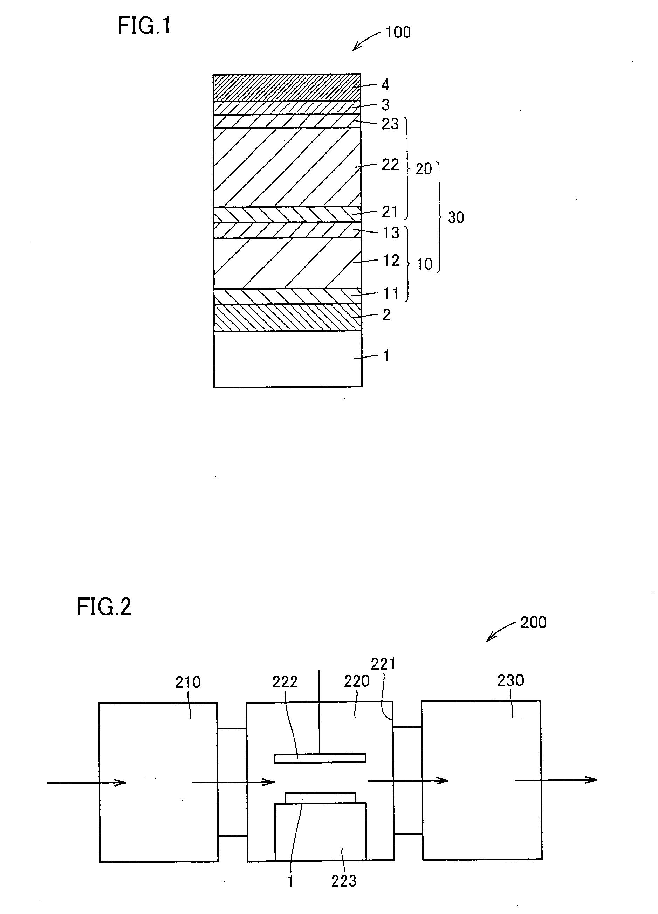

Referring to Figs. 1 and 2, one embodiment of the method of manufacturing a silicon-based thin-film photoelectric conversion device according to the present invention is characterized in that the method includes the steps of forming a transparent conductive film 2 on a substrate 1, and forming a double pin structure stack body 30 by successively forming a first p-type semiconductor layer 11, an i-type amorphous silicon-based photoelectric conversion layer 12, a first n-type semiconductor layer 13, a second p-type semiconductor layer 21, an i-type microcrystalline silicon-based photoelectric conversion layer 22, and a second n-type semiconductor layer 23 on transparent conductive film 2, the step of forming double pin structure stack body 30 is performed in an identical plasma CVD film deposition chamber 220, and first p-type semiconductor layer 11, i-type amorphous silicon-based photoelectric conversion layer 12 and first n-type semiconductor layer 13 are formed under such conditions that a film deposition pressure in the plasma CVD film deposition chamber is not lower than 200Pa and not higher than 3000Pa and power density per unit electrode area is not lower than 0.01W/cm² and not higher than 0.3W/cm².

Namely, referring to Figs. 1 and 2, in the method of manufacturing the silicon-based thin-film photoelectric conversion device in the present embodiment, double pin structure stack body 30 is formed by successively forming, in identical plasma CVD film deposition chamber 220, first p-type semiconductor layer 11, i-type amorphous silicon-based photoelectric conversion layer 12, first n-type semiconductor layer 13, second p-type semiconductor layer 21, i-type microcrystalline silicon-based photoelectric conversion layer 22, and second n-type semiconductor layer 23 on transparent conductive film 2 formed on substrate 1. Here, first p-type semiconductor layer 11, i-type amorphous silicon-based photoelectric conversion layer 12 and first n-type semiconductor layer 13 are formed under such conditions that the film deposition pressure in the plasma CVD film deposition chamber is not lower than 200Pa and not higher than 3000Pa and the power density per unit electrode area is not lower than 0.01 W/cm² and not higher than 0.3 W/cm². In the present embodiment, a distance between a cathode 222 and an anode 223 in identical plasma CVD film deposition chamber 220 is preferably in a range from at least 3mm to at most 20mm and the distance is preferably fixed.

Conventionally, in forming a photoelectric conversion device having double pin structure stack body 30 constituted of an amorphous pin structure stack body 10 having i-type amorphous silicon-based photoelectric conversion layer 12 and a microcrystalline pin structure stack body 20 having i-type microcrystalline silicon-based photoelectric conversion layer 22 (such a silicon-based thin-film photoelectric conversion device having the double pin structure stack body is also referred to as the stack-type silicon-based thin-film photoelectric conversion device hereinafter), respective pin structure stack bodies are normally formed in separate plasma CVD film deposition chambers. In the plasma CVD film deposition chamber for forming i-type microcrystalline silicon-based photoelectric conversion layer 22, in order to form a film of high quality, a small distance between the cathode and the anode is set. Specifically, the film should be formed under such conditions that the distance between the cathode and the anode is set, for example, to 3mm to 20mm, preferably to 5mm to 15mm, and more preferably to 7mm to 12mm, and a high pressure is set in the plasma CVD film deposition chamber. On the other hand, in the plasma CVD film deposition chamber for forming i-type amorphous silicon-based photoelectric conversion layer 12, a greater distance between the cathode and the anode has normally been set. This is because, when a small distance between the cathode and the anode is set, cathode in-plane non-uniformity under such a distance condition further affects cathode in-plane distribution of electric field strength between the cathode and the substrate on the anode, and because, in forming i-type amorphous silicon-based photoelectric conversion layer 12, as compared with forming i-type microcrystalline silicon-based photoelectric conversion layer 22, a raw material gas to be introduced into the plasma CVD film deposition chamber has such a gas composition as facilitating discharge and a degree of freedom of the distance between the cathode and the anode is greater.

In order to form the pin structure stack body having i-type amorphous silicon-based photoelectric conversion layer 12 and the pin structure stack body having i-type microcrystalline silicon-based photoelectric conversion layer 22 in identical plasma CVD film deposition chamber 220 as in the present embodiment, an electrode structure, in which a small distance is set between cathode 222 and anode 223, should be provided in order to form i-type microcrystalline silicon-based photoelectric conversion layer 22 of high quality, and i-type amorphous silicon-based photoelectric conversion layer 12 is formed by using the electrode structure the same as above.

It can readily be derived based on Paschen's law that discharge is facilitated by setting a high pressure for forming a film in the plasma CVD film deposition chamber when the distance between cathode 222 and anode 223 is made smaller. In the present invention, however, utilizing an effect that has not conventionally been conceived, i.e., an effect to suppress introduction or diffusion of an impurity by setting the conditions for forming amorphous pin structure stack body 10 having i-type amorphous silicon-based photoelectric conversion layer 12 such that a film deposition pressure is higher and power density per unit area of cathode 222 is lower than normal conditions, a stack-type silicon-based thin-film photoelectric conversion device 100 attaining high photoelectric conversion efficiency can be manufactured even when double pin structure stack body 30 is repeatedly formed in identical plasma CVD film deposition chamber 220.

In the present embodiment, first p-type semiconductor layer 11, i-type amorphous silicon-based photoelectric conversion layer 12 and first n-type semiconductor layer 13 are successively formed under such conditions that the film deposition pressure is not lower than 200Pa and not higher than 3000Pa and the power density per unit electrode area is not lower than 0.01 W/cm² and not higher than 0.3W/cm², so that amorphous pin structure stack body 10 (referring to a stack body in which a p-type layer, an i-type layer and an n-type layer are formed in this order and the i-type layer is amorphous, hereinafter) can be formed in the identical plasma CVD film deposition chamber. Here, in any of the present embodiment and other embodiments, as electric power is supplied to the cathode in forming the pin structure stack body, the power density per unit electrode area refers to power density per unit electrode area of the cathode.

When first n-type semiconductor layer 13 is formed under such conditions, diffusion to other layers of the n-type impurity atoms within first n-type semiconductor layer 13 and the remaining film in the film deposition chamber is less likely and the n-type impurity atoms do not affect second p-type semiconductor layer 21 and i-type microcrystalline silicon-based photoelectric conversion layer 22.

First n-type semiconductor layer 13 may be formed from any of an amorphous semiconductor and a crystalline semiconductor, however, the crystalline semiconductor is desirable. As a crystal portion included in the crystalline semiconductor is highly efficiently doped with n-type impurity atoms, inclusion of the crystal portion in first n-type semiconductor layer 13 can bring about desired conductivity without increasing concentration of n-type impurity atoms. Therefore, the concentration of the n-type impurity atoms in first n-type semiconductor layer 13 can be lowered and diffusion thereof to other layers can be suppressed.

In addition, first p-type semiconductor layer 11 and i-type amorphous silicon-based photoelectric conversion layer 12 obtained under the conditions for forming amorphous pin structure stack body 10 as above are less likely to be affected by the n-type impurity atoms in the remaining film formed in the plasma CVD film deposition chamber in the preceding process for forming second n-type semiconductor layer 23, even when the double pin structure stack body is repeatedly formed.

The film deposition pressure not lower than 200Pa is a pressure condition higher than a conventional condition for forming an amorphous silicon-based semiconductor layer (for example, approximately from 100Pa to 120Pa). By forming first p-type semiconductor layer 11 and i-type amorphous silicon-based photoelectric conversion layer 12 at a high film deposition pressure, mean free path (travel distance within the plasma CVD film deposition chamber) of the n-type impurity atoms released from second n-type semiconductor layer 23 that has adhered to cathode 222 and/or inner surface 221 before formation of these layers is decreased, and an amount of n-type impurity atoms taken into first p-type semiconductor layer 11 and i-type amorphous silicon-based photoelectric conversion layer 12 to be formed can be decreased. In addition, by forming first p-type semiconductor layer 11 and i-type amorphous silicon-based photoelectric conversion layer 12 under such formation condition as the film deposition pressure not higher than 3000Pa, a silicon-based semiconductor thin film attaining film quality excellent for a thin-film photoelectric conversion device can be formed.

Moreover, by forming first p-type semiconductor layer 11 and i-type amorphous silicon-based photoelectric conversion layer 12 at low power density not higher than 0.3W/cm² per unit electrode area, energy of electrons and ions in plasma that collide with cathode 222 can be lowered. As the n-type impurity atoms are expelled from second n-type semiconductor layer 23 that adheres to cathode 222 by the electrons and ions in the plasma, by lowering the energy thereof, the amount of the n-type impurity atoms taken into first p-type semiconductor layer 11 and i-type amorphous silicon-based photoelectric conversion layer 12 to be formed can be decreased. Further, by forming first p-type semiconductor layer 11 and i-type amorphous silicon-based photoelectric conversion layer 12 under such formation condition as the power density not lower than 0.01 W/cm², a silicon-based semiconductor thin film attaining film quality excellent for a thin-film photoelectric conversion device can be formed.

Consequently, double pin structure stack body 30 can continuously be formed on transparent conductive film 2 on next substrate 1 without performing the step of removing the remaining film formed on the cathode and/or the inner surface in the plasma CVD film deposition chamber and a next stack-type silicon-based thin-film photoelectric conversion device 100 can be manufactured.

In addition, by forming i-type amorphous silicon-based photoelectric conversion layer 12 under the formation condition above, an amount of introduction into i-type amorphous silicon-based photoelectric conversion layer 12, of p-type impurity atoms in the p-type semiconductor layer that adheres to cathode 222 and/or inner surface 221 in formation of first p-type semiconductor layer 11 is decreased.

By forming the p-type layer, the i-type layer and the n-type layer in this order in each pin structure stack body above, impurity atoms affect less the i-type layer serving as the photoelectric conversion layer, as compared with formation in the order of the n-type layer, the i-type layer and the p-type layer. This may be because, influence of introduction of the n-type impurity atoms (such as phosphorus atoms) into the i-type layer is greater than influence of introduction of the p-type impurity atoms (such as boron atoms), and therefore, formation of the n-type layer after formation of the i-type layer affects the i-type layer less than formation of the p-type layer after formation of the i-type layer.

In the present embodiment, referring to Fig. 1, first p-type semiconductor layer 11 has a thickness preferably not smaller than 2nm and more preferably not smaller than 5nm, in view of providing sufficient internal electric field to i-type amorphous silicon-based photoelectric conversion layer 12. In addition, first p-type semiconductor layer 11 has a thickness not larger than 50nm and more preferably not larger than 30nm, in view of necessity to suppress an amount of light absorption on an incident side of an inactive layer. I-type amorphous silicon-based photoelectric conversion layer 12 has a thickness preferably not smaller than 0.1 µm in view of a function sufficient as the amorphous thin-film photoelectric conversion layer. In addition, i-type amorphous silicon-based photoelectric conversion layer 12 has a thickness preferably not larger than 0.5µm and more preferably not larger than 0.4µm in view of necessity of sufficient internal electric field. First n-type semiconductor layer 13 has a thickness preferably not smaller than 2nm and more preferably not smaller than 5nm, in view of providing sufficient internal electric field to i-type amorphous silicon-based photoelectric conversion layer 12. In addition, first n-type semiconductor layer 13 has a thickness preferably not larger than 50nm and more preferably not larger than 30nm in view of facilitated operation for decreasing an amount of n-type impurity atoms within the remaining film that may diffuse into the i-type amorphous silicon-based photoelectric conversion layer during the step of etching the remaining film which will be described later and for removing the remaining film containing the n-type impurity atoms.

In addition, referring to Fig. 1, second p-type semiconductor layer 21 has a thickness preferably not smaller than 2nm and more preferably not smaller than 5nm, in view of providing sufficient internal electric field to i-type microcrystalline silicon-based photoelectric conversion layer 22. In addition, second p-type semiconductor layer 21 has a thickness preferably not larger than 50nm and more preferably not larger than 30nm, in view of necessity to suppress an amount of light absorption on an incident side of an inactive layer. I-type microcrystalline silicon-based photoelectric conversion layer 22 has a thickness preferably not smaller than 0.5µm and more preferably not smaller than 1µm, in view of a function sufficient as the silicon-based thin film photoelectric conversion layer containing microcrystals. In addition, i-type microcrystalline silicon-based photoelectric conversion layer 22 has a thickness preferably not larger than 20µm and more preferably not larger than 15µm in view of necessity to ensure productivity of the device. Second n-type semiconductor layer 23 has a thickness preferably not smaller than 2nm and more preferably not smaller than 5nm, in view of providing sufficient internal electric field to i-type microcrystalline silicon-based photoelectric conversion layer 22. In addition, second n-type semiconductor layer 23 has a thickness preferably not larger than 50nm and more preferably not larger than 30nm in view of necessity to suppress an amount of light absorption in an inactive layer.

First p-type semiconductor layer 11 is formed of an amorphous silicon-based semiconductor or a crystalline silicon-based semiconductor, and formed under such conditions that the film deposition pressure is not lower than 200Pa and not higher than 3000Pa, preferably not lower than 300Pa and not higher than 2000Pa, and further preferably not lower than 400Pa and not higher than 1500Pa. In addition, first p-type semiconductor layer 11 is formed under such conditions that the power density per unit electrode area is not lower than 0.01 W/cm² and not higher than 0.3W/cm², preferably not lower than 0.01 S W/cm² and not higher than 0.2W/cm², and further preferably not lower than 0.02W/cm² and not higher than 0.15W/cm². In addition, a temperature of an underlying base of substrate 1 is preferably not higher than 250°C. Here, the temperature of the underlying base of the substrate refers to a temperature of the underlying base on which the substrate is placed and it is substantially equal to the temperature of the substrate. In the present embodiment, substrate 1 is normally placed on anode 223 and the temperature of the underlying base here refers to the temperature of the anode. In addition, a raw material gas to be introduced in the plasma CVD film deposition chamber preferably includes a silane-based gas and a diluent gas containing a hydrogen gas. The raw material gas may contain methane, trimethyl diborane, or the like in order to lower the amount of light absorption in first p-type semiconductor layer 11. Thus, the p-type semiconductor layer that does not permit the p-type impurity atoms to affect the i-type amorphous silicon-based photoelectric conversion layer to be formed next can be formed. Though the impurity atom determining the conductivity type of first p-type semiconductor layer 11 (hereinafter, referred to as conductivity-type-determining impurity atom) is not particularly limited, boron atom or aluminum atom is preferred in view of high doping effect and versatility.

I-type amorphous silicon-based photoelectric conversion layer 12 is formed under such conditions that the film deposition pressure is not lower than 200Pa and not higher than 3000Pa, preferably not lower than 300Pa and not higher than 2000Pa, and further preferably not lower than 400Pa and not higher than 1500Pa. In addition, i-type amorphous silicon-based photoelectric conversion layer 12 is formed under such conditions that the power density per unit electrode area is not lower than 0.01 W/cm² and not higher than 0.3W/cm², preferably not lower than 0.15W/cm² and not higher than 0.2W/cm², and further preferably not lower than 0.02W/cm² and not higher than 0.15 W/cm². In addition, a temperature of the underlying base of substrate 1 is preferably not higher than 250°C. Moreover, as to the raw material gas to be introduced into the plasma CVD film deposition chamber, a flow rate of the diluent gas is greater than that of the silane-based gas preferably by at least 5 times and preferably by at most 20 times, and more preferably by at most 15 times. The amorphous i-type photoelectric conversion layer of high film quality can thus be formed.

First n-type semiconductor layer 13 is formed of an amorphous silicon-based semiconductor or a crystalline silicon-based semiconductor, and formed under such conditions that the film deposition pressure is not lower than 200Pa and not higher than 3000Pa, preferably not lower than 300Pa and not higher than 2000Pa, and further preferably not lower than 400Pa and not higher than 1500Pa. In addition, first n-type semiconductor layer 13 is formed under such conditions that the power density per unit electrode area is not lower than 0.01 W/cm² and not higher than 0.3 W/cm², preferably not lower than 0.15W/cm² and not higher than 0.2W/cm², and further preferably not lower than 0.02W/cm² and not higher than 0.15W/cm². In addition, a temperature of the underlying base of substrate 1 is preferably not higher than 250°C. Thus, first n-type semiconductor layer 13 that does not permit n-type impurity atoms to affect i-type amorphous silicon-based photoelectric conversion layer 12 and subsequently formed microcrystalline pin structure stack body 20 (referring to a stack body in which the p-type layer, the i-type layer and the n-type layer are formed in this order and the i-type layer is microcrystalline, hereinafter) formed of second p-type semiconductor layer 21, i-type microcrystalline silicon-based photoelectric conversion layer 22 and second n-type semiconductor layer 23 can be formed.

In addition, as thin films having a pin structure can repeatedly be formed using the identical plasma CVD film deposition chamber, the concentration of impurity nitrogen atoms in first n-type semiconductor layer 13 can be not higher than 1 × 10¹⁹cm⁻³ and the concentration of impurity oxygen atoms therein can be not higher than 1 × 10²cm⁻³. Thus, excellent Ohmic contact between first n-type semiconductor layer 13 and second p-type semiconductor layer 21 can be obtained without interposing an extra recombination layer.

Though the conductivity-type-determining impurity atom for first n-type semiconductor layer 13 is not particularly limited, phosphorous atom is preferred in view of high doping efficiency and versatility. In addition, the content of phosphorus atoms relative to silicon atoms in the raw material gas is preferably not lower than 0.05 atomic % and more preferably not lower than 0.1 atomic % in view of sufficient doping effect, and preferably not higher than 3 atomic % and more preferably not higher than 1 atomic % in view of avoiding deterioration in film quality. Here, atomic % refers to indication in percentage of a ratio of the number of doping atoms to the number of silicon atoms. Thus, the concentration of the conductivity-type-determining impurity atom for the first n-type semiconductor layer can be not higher than 3×10¹⁹cm⁻³.

Second p-type semiconductor layer 21 should only be formed under general formation conditions (for example, described in Japanese Patent Laying-Open No. 2000-243993 and the like), and it may be implemented by a p-type microcrystalline silicon layer formed, for example, under such conditions that the film deposition pressure is in a range approximately from 600Pa to 3000Pa and the power density per unit electrode area is in a range approximately from 0.05W/cm² to 0.3W/cm².

Second p-type semiconductor layer 21 may be implemented, for example, by a p-type amorphous or microcrystalline silicon thin film doped with boron atoms serving as the conductivity-type-determining impurity atom by at least 0.01 atomic % and at most 5 atomic %. Second p-type semiconductor layer 21 is preferably formed under such conditions that the temperature of the underlying base of substrate 1 is not higher than 250°C and a raw material gas to be introduced into the plasma CVD film deposition chamber includes a silane-based gas and a diluent gas containing a hydrogen gas. In addition, in order to decrease an absorption amount in second p-type semiconductor layer 21, the raw material gas may contain methane, trimethyl diborane, or the like. The temperature of the underlying base of substrate 1 is preferably not higher than 250°C, so that second p-type semiconductor layer 21 can be formed without affecting i-type amorphous silicon-based photoelectric conversion layer 12.

In addition, as thin films having a pin structure can repeatedly be formed using the identical plasma CVD film deposition chamber, the concentration of impurity nitrogen atoms in second p-type semiconductor layer 21 can be not higher than 1×10¹⁹cm⁻³ and the concentration of impurity oxygen atoms therein can be not higher than 1×10²⁰cm⁻³. Thus, excellent Ohmic contact between first n-type semiconductor layer 13 and second p-type semiconductor layer 21 can be obtained without interposing an extra recombination layer.

Though the conductivity-type-determining impurity atom for second p-type semiconductor layer 21 is not particularly limited, boron atom, aluminum atom, or the like is preferred in view of high doping efficiency and versatility. Thus, the concentration of the conductivity-type-determining impurity in second p-type semiconductor layer 21 can be not higher than 5×10¹⁹cm⁻³ and excellent Ohmic contact between first n-type semiconductor layer 13 and second p-type semiconductor layer 21 can be obtained without interposing an extra recombination layer.

I-type microcrystalline silicon-based photoelectric conversion layer 22 should only be formed under general formation conditions (for example, described in Japanese Patent Laying-Open No. 2000-243993 and the like), and it may be implemented by an i-type microcrystalline silicon layer formed, for example, under such conditions that the film deposition pressure is in a range approximately from 600Pa to 3000Pa and the power density per unit electrode area is in a range approximately from 0.05 W/cm² to 0.3W/cm².

I-type microcrystalline silicon-based photoelectric conversion layer 22 can be formed by setting the temperature of the underlying base of substrate 1 preferably to a temperature not higher than 250°C, without affecting i-type amorphous silicon-based photoelectric conversion layer 12. In addition, as to the raw material gas to be introduced into the plasma CVD film deposition chamber, a flow rate of the diluent gas is greater than that of the silane-based gas preferably by at least 30 times and preferably by at most 100 times, and more preferably by at most 80 times. Thus, i-type microcrystalline silicon-based photoelectric conversion layer 22 having a peak intensity ratio I₅₂₀/I₄₈₀ of peak at 520nm⁻¹ with respect to peak at 480nm⁻¹ measured with Raman spectroscopy, of not smaller than 5 and not larger than 10, can be obtained. Such i-type microcrystalline silicon-based photoelectric conversion layer 22 can achieve a sufficient ratio of crystallization, and the i-type silicon-based photoelectric conversion layer can be formed with excellent reproducibility even after the treatment for removing (also referred to as cleaning hereinafter) the remaining film formed on the cathode and/or the inner surface in the film deposition chamber, which will be described later.

Second n-type semiconductor layer 23 should only be formed under general formation conditions (for example, described in Japanese Patent Laying-Open No. 2000-243993 and the like), and it may be implemented by an n-type microcrystalline silicon layer formed, for example, under such conditions that the film deposition pressure is in a range approximately from 600Pa to 3000Pa and the power density per unit electrode area is in a range approximately from 0.05W/cm² to 0.3W/cm².

Second n-type semiconductor layer 23 can be formed by setting the temperature of the underlying base of substrate 1 preferably to a temperature not higher than 250°C, without affecting the i-type amorphous silicon-based photoelectric conversion layer. Here, though the conductivity-type-determining impurity atom for second n-type semiconductor layer 23 is not particularly limited, phosphorous atom is preferred in view of high doping efficiency and versatility. In addition, the content of phosphorus atoms relative to silicon atoms in the raw material gas is preferably not lower than 0.1 atomic % and more preferably not lower than 0.3 atomic % in view of sufficient doping effect, and preferably not higher than 5 atomic % and more preferably not higher than 3 atomic % in view of avoiding deterioration in film quality.

By thus continuously forming amorphous pin structure stack body 10 (that is, first p-type semiconductor layer 11, i-type amorphous silicon-based photoelectric conversion layer 12 and first n-type semiconductor layer 13) and microcrystalline pin structure stack body 20 (that is, second p-type semiconductor layer 21, i-type microcrystalline silicon-based photoelectric conversion layer 22 and second n-type semiconductor layer 23) in the identical plasma CVD film deposition chamber, the stack-type silicon-based thin-film photoelectric conversion device having high photoelectric conversion efficiency can be manufactured at low cost and high efficiency.

### (Embodiment 2)

Referring to Figs. 1 and 2, another embodiment of the method of manufacturing a silicon-based thin-film photoelectric conversion device according to the present invention includes the steps of carrying silicon-based thin-film photoelectric conversion device 100 including the double pin structure stack body out of plasma CVD film deposition chamber 220 and removing the remaining film on cathode 222 and/or inner surface 221 in plasma CVD film deposition chamber 220, after the step of forming the double pin structure stack body in Embodiment 1 above. Namely, the method of manufacturing the silicon-based thin-film photoelectric conversion device in the present embodiment is characterized in that, after double pin structure stack body 30 is formed, silicon-based thin-film photoelectric conversion device 100 including double pin structure stack body 30 is carried out of plasma CVD film deposition chamber 220 and the remaining film on cathode 222 and/or inner surface 221 in plasma CVD film deposition chamber 220 is removed.

After the double pin structure stack body is formed in the identical plasma CVD film deposition chamber as shown in Embodiment 1, silicon-based thin-film photoelectric conversion device 100 including the double pin structure stack body is carried out, and thereafter the remaining film formed on the cathode and/or the inner surface in the plasma CVD film deposition chamber is removed, so that stack-type silicon-based thin-film photoelectric conversion device 100 having excellent quality and performance can repeatedly be manufactured in the identical plasma CVD film deposition chamber.

The next stack-type silicon-based thin-film photoelectric conversion device can also be formed by forming a next double pin structure stack body in identical plasma CVD film deposition chamber 220 without performing the step of removing the remaining film on cathode 222 and/or inner surface 221 in plasma CVD film deposition chamber 220 as shown in the present embodiment, after forming one stack-type silicon-based thin-film photoelectric conversion device by forming the double pin structure stack body in identical plasma CVD film deposition chamber 220 as shown in Embodiment 1.

In view of prevention of contamination by the remaining film in plasma CVD film deposition chamber 220, however, rather than successively forming amorphous pin structure stack body 10 of next stack-type silicon-based thin-film photoelectric conversion device 100 on transparent conductive film 2 of next substrate 1 after formation of one stack-type silicon-based thin-film photoelectric conversion device 100, it is preferred to completely remove the remaining film on cathode 222 and/or inner surface 221 in plasma CVD film deposition chamber 220 before formation of amorphous pin structure stack body 10, so as to completely eliminate influence of diffusion of impurity atoms (n-type dopant) in the second n-type layer in the remaining film into amorphous pin structure stack body 10 of next stack-type silicon-based thin-film photoelectric conversion device 100. Thus, the stack-type silicon-based thin-film photoelectric conversion device having excellent quality and performance can successively be formed with excellent reproducibility.

Namely, the method of manufacturing the silicon-based thin-film photoelectric conversion device of the present embodiment is characterized by including the step of removing the remaining film on cathode 222 and/or inner surface 221 in plasma CVD film deposition chamber 220 as the step for eliminating influence of impurity atoms (p-type impurity atoms and n-type impurity atoms) in the p-type layer and the n-type layer in the remaining film in plasma CVD film deposition chamber 220 onto the pin structure stack body at the time of formation of the pin structure stack body to be performed in the next step. With such a step, even if a plurality of photoelectric conversion devices are continuously manufactured in a single chamber system, influence of impurity atoms in the remaining film can be eliminated and introduction of the n-type impurity atoms into the first p-type semiconductor layer and the i-type amorphous silicon-based thin film photoelectric conversion layer in the pin structure stack body can significantly be suppressed. Thus, the pin structure stack body having excellent quality and performance can repeatedly be formed and the stack-type silicon-based thin-film photoelectric conversion device including the double pin structure stack body can be manufactured using the single chamber system. Then, facilities can be simplified as compared with manufacturing facilities based on the in-line system, the multi-chamber system, or combination thereof, and lower cost can be achieved.

In the present embodiment, the step of removing the remaining film can be performed by using gas plasma decomposition, in which at least one gas selected from the group consisting of a hydrogen gas, an inert gas and a fluorine-based cleaning gas is turned to plasma. Owing to such a step of removing the remaining film, the pin structure stack body can repeatedly be formed and the stack-type silicon-based thin-film photoelectric conversion device can be manufactured with good reproducibility. An operation to etch the remaining film can preferably be performed by using any of the hydrogen gas, the inert gas and the fluorine-based cleaning gas, however, use of nitrogen trifluoride gas plasma obtained by turning a nitrogen trifluoride gas into plasma is preferred in view of relatively high rate of etching the remaining film. Here, generally, an argon gas is preferred as the inert gas, although depending on individual etching conditions.

In the step of removing the remaining film in the present embodiment, the entire remaining film on the cathode and/or inner surface in the plasma CVD film deposition chamber can be removed. Here, in order to avoid influence of impurity atoms in the p-type layer located as the lowermost layer (referring to a layer closest to the cathode hereinafter) in the remaining film, slight overetching or underetching is necessary.

In the case of overetching, the remaining film formed when the double pin structure stack body above is formed once is overetched to a depth comparable to its thickness plus approximately 5% to 10% of the thickness. By doing so, influence of the impurity atoms in the remaining film can be eliminated. Repeated overetching of the remaining film formed on the cathode in the plasma CVD film deposition chamber, however, results in gradual etching of a pre-depo film (a pre-deposited film hereinafter) on the cathode formed for the purpose of stabilizing discharge and the metal surface of the cathode is exhibited, which may significantly affect a portion having a thickness of approximately several ten nm at the initial stage of forming the next double pin structure stack body.

In order to solve the problem above, underetching for leaving a portion close to the cathode, of the remaining film formed when the double pin structure stack body above is formed once, may be selected. Underetching is performed in such a manner that the remaining film is etched away from the surface layer thereof as far as the first n layer located closest to the cathode and/or the inner surface and preferably the i-type layer is etched away to a depth of 10nm or greater in the direction of thickness thereof. If the depth of etching away the i-type layer is less than 10nm in the direction of thickness, it becomes difficult to completely eliminate influence of impurity atoms (n-type dopant) in the first n-type layer that have been diffused in the i-type layer. Here, etching away of the i-type layer to a depth comparable to 90% or less of the thickness thereof is preferred, and etching away of the i layer to a depth comparable to 80% or less of the thickness thereof is further preferred. Etching of the i-type layer to a depth greater than 90% of the thickness thereof brings about influence of the impurity atoms (p-type dopant) in the p-type layer that underlies the i-type layer, and an amount of doping the p layer to be formed in the next step may deviate from an optimal value. Therefore, preferably, together with the n layer, the i layer is etched to a depth comparable to approximately 80% of the thickness thereof, in order to completely eliminate influence of the impurity atoms in the remaining film. A next substrate is carried into the plasma CVD film deposition chamber after the step of removing the remaining film has thus ended, and the double pin structure stack body is repeatedly formed. Thus, the next stack-type silicon-based thin-film photoelectric conversion device including the double pin structure stack body is manufactured.

By repeating the step of forming the double pin structure stack body a plurality of times together with the underetching step above, remaining films that have not been etched are stacked on the cathode, in the number corresponding to the number of times of formation of the double pin structure stack body. When manufacturing of the stack-type silicon-based thin-film photoelectric conversion device is thus continued, the stacked remaining films peel off from the cathode surface due to internal stress and may be taken into the pin structure stack body as powders having a diameter of several µm. The powders cause such a point defect that upper and lower electrodes are short-circuited to each other, and considerably lower the product yield of the photoelectric conversion device to 30% or less.

Here, if the remaining film has peeled off from the cathode after fabrication of the photoelectric conversion device, the entire remaining film on the cathode is preferably removed. Even when the remaining film has not peeled off from the cathode, it is more preferred to prevent occurrence of a point defect as above before the remaining film peels off and to maintain high yield in manufacturing the photoelectric conversion device. Though a degree of peeling off of the remaining film significantly varies depending on film deposition conditions or a surface state of the electrode when the film adheres, in fabricating a silicon-based thin film in the plasma CVD film deposition chamber, generally, peeling off of the remaining film is likely when the accumulated film thickness of the remaining films formed on the cathode is not smaller than 10µm and not larger than 1000µm. Therefore, all the remaining films stacked on the cathode are desirably removed when the accumulated film thickness of the remaining films on the cathode is preferably not smaller than 10µm and not larger than 800µm and more preferably not smaller than 300µm and not larger than 500µm.

The step of removing the remaining films stacked on the cathode can be performed by using gas plasma obtained by turning the hydrogen gas, the inert gas, the fluorine-based cleaning gas, or a gas mixture containing these gases at an arbitrary ratio to plasma, however, a fluorine-based cleaning gas, for example, of nitrogen trifluoride is preferably used in view of relatively high rate of etching the remaining film. For example, by introducing the gas mixture including 10 to 30 volume % nitrogen trifluoride gas and 90 to 70 volume % argon gas as the etching gas and providing plasma discharge at a pressure not higher than 300pa, an etching rate not lower than 10nm/s can be obtained. After such cleaning of the cathode, in order to stabilize the cathode surface, pre-deposition (pre-depo) of a silicon film on the cathode surface is performed and the step of forming the pin structure stack body can again be continued.

In particular in the step of overetching the remaining film formed on the cathode, attention should be paid not to completely remove an underlying film formed on the metal surface for stabilizing the cathode surface. If the underlying film is completely removed, conditions for forming the first p-type semiconductor layer in the double pin structure stack body may become unstable, and therefore, pre-deposition of the underlying film is preferably performed again.

### (Embodiment 3)

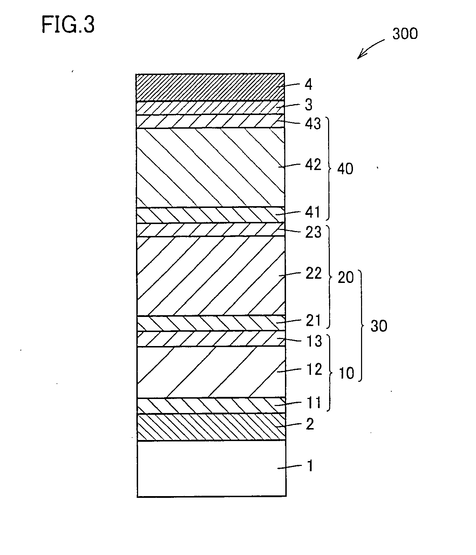

Referring to Fig. 3, yet another embodiment of the method of manufacturing the silicon-based thin-film photoelectric conversion device according to the present invention is characterized in that at least one crystalline pin structure stack body 40 formed from a p-type semiconductor layer 41, an i-type crystalline silicon-based photoelectric conversion layer 42 and an n-type semiconductor layer 43 is stacked on second n-type semiconductor layer 23 of double pin structure stack body 30 formed with the manufacturing method according to Embodiment 1 or Embodiment 2 above.

Specifically, referring to Fig. 3, the silicon-based thin-film photoelectric conversion device in the present embodiment is implemented by a stack-type silicon-based thin-film photoelectric conversion device 300 having such a structure that three or more pin structure stack bodies formed from amorphous pin structure stack body 10, microcrystalline pin structure stack body 20 and one or more crystalline pin structure stack body 40 (referring to the pin structure stack body formed from the p-type layer, the i-type crystalline layer, and the n-type layer, hereinafter) when viewed from substrate 1 side are stacked, and achieves further higher photoelectric conversion efficiency as a result of higher efficiency in light absorption from a light source. In view of higher efficiency in light absorption, each crystal in i-type crystalline silicon-based photoelectric conversion layer 42 preferably has a diameter greater than that of each crystal in i-type microcrystalline silicon-based photoelectric conversion layer 22. Meanwhile, p-type semiconductor layer 41 and n-type semiconductor layer 43 are the same as first p-type semiconductor layer 11 and first n-type semiconductor layer 13 in Embodiment 1, respectively.

### (Embodiment 4)

The silicon-based thin-film photoelectric conversion device manufactured with the manufacturing method in Embodiment 2 will more specifically be described. The silicon-based thin-film photoelectric conversion device in the present embodiment is implemented by the stack-type silicon thin-film photoelectric conversion device, and referring to Fig. 1, it is a tandem-type silicon-based thin-film photoelectric conversion device obtained by successively forming, on transparent substrate 1, transparent conductive film 2, first p-type semiconductor layer 11, i-type amorphous silicon-based photoelectric conversion layer 12 and first n-type semiconductor layer 13 forming amorphous pin structure stack body 10, second p-type semiconductor layer 21, i-type microcrystalline silicon-based photoelectric conversion layer 22 and second n-type semiconductor layer 23 forming microcrystalline pin structure stack body 20, a conductive film 3, and a metal electrode 4.

Referring to Figs. 1, 2, and 4, the silicon-based thin-film photoelectric conversion device in the present embodiment is manufactured in the following manner. Here, referring to Fig. 2, a plasma CVD apparatus 200 used in manufacturing the present photoelectric conversion device includes a heating chamber 210, film deposition chamber 220 and an exit chamber 230, and substrate 1 is transferred between the chambers in a direction shown with an arrow.

Initially, transparent conductive film 2 is formed on transparent substrate 1 made of glass or the like. Transparent conductive film 2 is not particularly limited so long as it transmits light and has a conductivity type, and a transparent conductive oxide film or the like composed, for example, of Sn0₂, ITO (indium tin oxide hereinafter), and ZnO is preferably formed.

Thereafter, in step (hereinafter, step is abbreviated as S) 1, substrate 1 on which transparent conductive film 2 is formed is carried into heating chamber 210 of plasma CVD apparatus 200. Then, in S2, the substrate is heated and held in heating chamber 210 for a prescribed period until the temperature of the substrate reaches a film deposition temperature. Thereafter, in S3, substrate 1 on which transparent conductive film 2 is formed and of which temperature has reached the film deposition temperature is carried into film deposition chamber 220.

In succession, in S4, first p-type semiconductor layer 11, i-type amorphous silicon-based photoelectric conversion layer 12 and first n-type semiconductor layer 13 forming amorphous pin structure stack body 10 and second p-type semiconductor layer 21, i-type microcrystalline silicon-based photoelectric conversion layer 22 and second n-type semiconductor layer 23 forming microcrystalline pin structure stack body 20 are continuously formed on transparent conductive film 2 on substrate 1 in identical film deposition chamber 220, so that the photoelectric conversion device including the double pin structure stack body is formed.

In film deposition chamber 220, initially, first p-type semiconductor layer 11 is formed on transparent conductive film 2 with a plasma CVD method. First p-type semiconductor layer 11 is formed under such conditions that the film deposition pressure is not lower than 200Pa and not higher than 3000Pa and the power density per unit electrode area is not lower than 0.01 W/cm² and not higher than 0.3W/cm². In addition, a temperature of the underlying base of substrate 1 is preferably not higher than 250°C. The raw material gas to be introduced into film deposition chamber 220 preferably includes a silane-based gas and a diluent gas containing a hydrogen gas. The raw material gas may contain methane, trimethyl diborane, or the like in order to lower the amount of light absorption. By setting the temperature of the underlying base of the substrate preferably to a temperature not higher than 250°C, first p-type semiconductor layer 11 is formed without affecting i-type amorphous silicon-based photoelectric conversion layer 12 to be formed next. In addition, first p-type semiconductor layer 11 can be formed with good reproducibility also after the step of etching the remaining film which will be described later. Boron atom, aluminum atom, or the like is preferably selected as the conductivity-type-determining impurity atom for first p-type semiconductor layer 11.

I-type amorphous silicon-based photoelectric conversion layer 12 is formed under such conditions that the film deposition pressure is not lower than 200Pa and not higher than 3000Pa and the power density per unit electrode area is not lower than 0.01 W/cm² and not higher than 0.3W/cm². In addition, a temperature of the underlying base of substrate 1 is preferably not higher than 250°C. Moreover, as to the raw material gas to be introduced into film deposition chamber 220, a flow rate of the diluent gas is greater than that of the silane-based gas preferably by at least 5 times, and a flow rate of the diluent gas is greater than that of the silane-based gas preferably by at most 20 times and more preferably by at most 15 times. By selecting such conditions, i-type amorphous silicon-based photoelectric conversion layer 12 of high film quality is formed.

First n-type semiconductor layer 13 is formed under such conditions that the film deposition pressure is not lower than 200Pa and not higher than 3000Pa and the power density per unit electrode area is not lower than 0.01 W/cm² and not higher than 0.3W/cm². A temperature of the underlying base of substrate 1 is preferably not higher than 250°C. By selecting such conditions, first n-type semiconductor layer 13 of high film quality is formed without affecting amorphous pin structure stack body 10 and microcrystalline pin structure stack body 20. Phosphorous can be selected as the conductivity-type-determining impurity atom for first n-type semiconductor layer 13. Here, the content of phosphorus atoms relative to silicon atoms in the raw material gas is preferably not lower than 0.05 atomic % and more preferably not lower than 0.1 atomic % in view of sufficient doping effect, and preferably not higher than 3 atomic % and more preferably not higher than 1 atomic % in view of avoiding deterioration in film quality. Thus, the concentration of the conductivity-type-determining impurity atom for the first n-type semiconductor layer can be not higher than 3×10¹⁹cm⁻³.

Second p-type semiconductor layer 21 should only be formed under general formation conditions, and it may be implemented by a p-type microcrystalline silicon layer formed, for example, under such conditions that the film deposition pressure is in a range approximately from 600Pa to 3000Pa and the power density per unit electrode area is in a range approximately from 0.05W/cm² to 0.3W/cm².

Second p-type semiconductor layer 21 is preferably formed to a thickness in a range from at least 2nm to at most 50nm under such a condition that the temperature of the underlying base of substrate 1 is not higher than 250°C. The raw material gas introduced into film deposition chamber 220 mainly contains a silane-based gas such as a silane gas and a diluent gas containing, for example, a hydrogen gas or the like, a flow rate of the diluent gas is greater than that of the silane-based gas by at least 100 times, and diborane is preferably used as the doping gas.

In addition, second p-type semiconductor layer 21 may be implemented, for example, by a p-type amorphous or microcrystalline silicon thin film doped with boron atoms serving as the conductivity-type-determining impurity atom by at least 0.01 atomic % and at most 5 atomic %. These conditions for second p-type semiconductor layer 21, however, are not limitative, and for example, aluminum atom or the like may also be used as the impurity atom. Alternatively, second p-type semiconductor layer 21 may be formed from a layer made of an alloy material such as amorphous and microcrystalline silicon carbide, amorphous silicon germanium, or the like. In addition, second p-type semiconductor layer 21 preferably has a thickness in a range from at least 2nm to at most 50nm. Alternatively, second p-type semiconductor layer 21 may also be implemented by a polycrystalline silicon-based thin film or an alloy-based thin film, or by a stack of a plurality of different thin films.

I-type microcrystalline silicon-based photoelectric conversion layer 22 should only be formed under general formation conditions, and it may be implemented by an i-type microcrystalline silicon layer formed, for example, under such conditions that the film deposition pressure is in a range approximately from 600Pa to 3000Pa and the power density per unit electrode area is in a range approximately from 0.05W/cm² to 0.3W/cm².

I-type microcrystalline silicon-based photoelectric conversion layer 22 is preferably formed to a thickness not smaller than 0.5µm and not larger than 20µm. I-type microcrystalline silicon-based photoelectric conversion layer 22 is preferably formed under such conditions that the temperature of the underlying base of substrate 1 is not higher than 250°C and a flow rate of the diluent gas is greater than that of the silane-based gas preferably by at least 30 times and at most 100 times. I-type microcrystalline silicon-based photoelectric conversion layer 22 thus obtained preferably has a peak intensity ratio I₅₂₀/I₄₈₀ of peak at 520nm⁻¹ with respect to peak at 480nm⁻¹ measured with Raman spectroscopy, of not smaller than 5 and not larger than 10. In addition, the i-type microcrystalline silicon-based photoelectric conversion layer may be implemented by an i-type microcrystalline silicon thin film or a microcrystalline silicon thin film containing a small amount of impurity, being of weak p-type or weak n-type, and having a sufficient photoelectric conversion function. Moreover, i-type microcrystalline silicon-based photoelectric conversion layer 22 is not limited to the microcrystalline silicon thin film above, and a thin film of silicon carbide, silicon germanium or the like representing alloy materials may be employed.

Second n-type semiconductor layer 23 should only be formed under general formation conditions, and it may be implemented by an n-type microcrystalline silicon layer formed, for example, under such conditions that the film deposition pressure is in a range approximately from 600Pa to 3000Pa and the power density per unit electrode area is in a range approximately from 0.05W/cm² to 0.3 W/cm².

Second n-type semiconductor layer 23 is preferably formed to a thickness in a range from at least 2nm to at most 50nm under such a condition that the temperature of the underlying base of substrate 1 is not higher than 250°C. In addition, second n-type semiconductor layer 23 may be implemented, for example, by a p-type amorphous or microcrystalline silicon thin film doped with phosphorus atoms serving as the conductivity-type-determining impurity atom by at least 0.1 atomic % and at most 5 atomic %. These conditions for the n-type semiconductor layer, however, are not limitative, and second n-type semiconductor layer 23 may be formed from an alloy material such as microcrystalline silicon carbide, silicon germanium or the like.

Referring next to Figs. 1, 2, and 4, in S5, after the photoelectric conversion device including the double pin structure stack body above is carried out of film deposition chamber 220 to exit chamber 230, in S6, whether abnormality such as peeling off of the remaining film on the cathode in film deposition chamber 220 has occurred or not is confirmed. If abnormality such as peeling off has occurred (YES in S6), desirably, all the remaining films on cathode 222 are removed with overetching in S7 and stabilization of the cathode surface shown in S8 (such as formation of a pre-depo film) is performed. On the other hand, if abnormality in the remaining film on cathode 222 has not occurred (NO in S6), the remaining film on cathode 222 and/or inner surface 221 in film deposition chamber 220 is etched (underetching or overetching) in S9, so that influence of the impurity atoms (n-type dopant) in the remaining film formed on cathode 222 and/or inner surface 221 in film deposition chamber 220 at the time of formation of the last n-type semiconductor layer is eliminated. Here, removal of the remaining film can be performed using gas plasma obtained by turning the hydrogen gas, the inert gas, the fluorine-based cleaning gas, or any gas mixture of these gases to plasma.

In the step of removing the remaining film, the entire remaining film formed on cathode 222 is normally removed. Here, in order to avoid influence of the impurity atoms (p-type dopant) in the p-type layer that is finally left in the step of etching the remaining film, slight overetching or underetching is necessary. In the case of overetching, the remaining film formed when the double pin structure stack body above is formed once is overetched to a depth comparable to its thickness plus approximately 5% to 10% of the thickness thereof. By doing so, influence of the impurity atoms in the remaining film can be eliminated. Repeated such overetching, however, results in gradual etching of the pre-depo film on the cathode formed for the purpose of stabilizing discharge and the metal surface of the cathode is exhibited, which may significantly affect a portion having a thickness of approximately several ten nm at the initial stage of forming the next double pin structure stack body.

In order to solve the problem above, underetching for leaving a portion close to the cathode, of the remaining film formed when the double pin structure stack body above is formed once, may be selected. Underetching is performed in such a manner that the remaining film is etched away from the surface layer thereof as far as the first n layer located closest to the cathode and/or the inner surface and preferably the amorphous i-type layer is etched away to a depth of 10nm or greater in the direction of thickness thereof. If the depth of etching away the amorphous i-type layer is less than 10nm in the direction of thickness, it becomes difficult to completely eliminate influence of impurity atoms (n-type dopant) in the first n-type layer that have been diffused in the i-type layer. Here, etching away to a depth comparable to 90% or less of the thickness of the i-type layer is preferred and etching away to a depth comparable to 80% or less of the thickness of the i layer is further preferred. Etching to a depth greater than 90% of the thickness of the i-type layer brings about influence of the impurity atoms (p-type dopant) in the p-type layer that underlies the i-type layer, and an amount of doping the p layer to be formed in the next step may deviate from an optimal value. Therefore, preferably, together with the n layer, the i layer is etched away to a depth comparable to approximately 80% of the thickness thereof, in order to completely eliminate influence of the impurity atoms in the remaining film. A next substrate is carried into the plasma CVD film deposition chamber after the step of removing the remaining film has thus ended, and the double pin structure stack body is repeatedly formed. Thus, the next stack-type silicon-based thin-film photoelectric conversion device including the double pin structure stack body is manufactured.

By repeating the step of forming the double pin structure stack body a plurality of times together with the underetching step above, remaining films that have not been etched are stacked on cathode 222, in the number corresponding to the number of times of formation of the double pin structure stack body. When the process is thus continued, the stacked remaining films peel off from the cathode surface due to internal stress and may be taken into the pin structure stack body as powders having a diameter of several µm. The powders cause such a point defect that upper and lower electrodes are short-circuited to each other, and considerably lower the product yield of the photoelectric conversion device to 30% or less. Here, if the remaining film has peeled off from cathode 222 after fabrication of the photoelectric conversion device, the entire remaining film on cathode 222 is preferably removed. Even when the remaining film has not peeled off from cathode 222, it is more preferred to prevent occurrence of a point defect as above before the remaining film peels off and to maintain high yield in manufacturing the photoelectric conversion device. Though a degree of peeling off of the remaining film significantly varies depending on film deposition conditions or a surface state of the electrode when the film adheres, in fabricating a silicon-based thin film in the plasma CVD film deposition chamber, generally, peeling off of the remaining film is likely when the accumulated film thickness of the remaining films formed on cathode 222 is not smaller than 10µm and not larger than 1000µm. Therefore, all the remaining films stacked on the cathode are desirably removed when the accumulated film thickness of the remaining films on cathode 222 is preferably not smaller than 10µm and not larger than 800µm and more preferably not smaller than 300µm and not larger than 500µm.

The step of removing the remaining films stacked on cathode 222 can be performed using gas plasma obtained by turning the hydrogen gas, the inert gas, the fluorine-based cleaning gas, or a gas mixture containing these gases at an arbitrary ratio to plasma, however, the fluorine-based cleaning gas, for example, of nitrogen trifluoride is preferably used in view of relatively high rate of etching the remaining film. For example, by introducing the gas mixture including 10 to 30 volume % nitrogen trifluoride gas and 90 to 70 volume % argon gas as the etching gas and providing plasma discharge at a pressure not higher than 300pa, an etching rate not lower than 10nm/s can be obtained. After such cleaning of cathode 222, in order to stabilize the cathode surface, pre-deposition (pre-depo) of a silicon film on the cathode surface is performed and the step of forming the pin structure stack body can again be continued.

Referring next to Fig. 1, after double pin structure stack body 30 is formed as above, conductive film 3 composed, for example, of ZnO is formed on second n-type semiconductor layer 23 of double pin structure stack body 30 and thereafter metal electrode 4 composed, for example, of Al, Ag, or the like is formed on conductive film 3. A back electrode portion is implemented by conductive film 3 and metal electrode 4, to thereby complete the photoelectric conversion device.

As described above, as the photoelectric conversion device in the present embodiment can be manufactured with the single chamber system, manufacturing facilities can be simplified as compared with the in-line system or the multi-chamber system. In addition, as the plasma CVD apparatus can operate for a long time without the film deposition chamber being opened, tact time in manufacturing can significantly be shortened and manufacturing cost can be reduced.

### (Embodiment 5)

Referring to Fig. 1, one embodiment of the silicon-based thin-film photoelectric conversion device according to the present invention is directed to stack-type silicon-based thin-film photoelectric conversion device 100 including transparent conductive film 2 formed on substrate 1 and double pin structure stack body 30, and characterized in that double pin structure stack body 30 is formed of first p-type semiconductor layer 11, i-type amorphous silicon-based photoelectric conversion layer 12, first n-type semiconductor layer 13, second p-type semiconductor layer 21, i-type microcrystalline silicon-based photoelectric conversion layer 22, and second n-type semiconductor layer 23 successively formed on transparent conductive film 2, and each of first n-type semiconductor layer 13 and second p-type semiconductor layer 21 has the concentration of impurity nitrogen atom of not higher than 1×10¹⁹cm⁻³ and the concentration of impurity oxygen atom of not higher than 1 × 10²⁰cm⁻³. With the manufacturing method shown in Embodiment 1 to Embodiment 4, the stack-type silicon-based thin-film photoelectric conversion device of high photoelectric conversion efficiency, in which each of first n-type semiconductor layer 13 and second p-type semiconductor layer 21 has the concentration of impurity nitrogen atom of not higher than 1×10¹⁹cm⁻³ and the concentration of impurity oxygen atom of not higher than 1×10²⁰cm⁻³, is obtained.

### (Embodiment 6)

Referring to Fig. 1, another embodiment of the silicon-based thin-film photoelectric conversion device according to the present invention is directed to stack-type silicon-based thin-film photoelectric conversion device 100 including transparent conductive film 2 formed on substrate 1 and double pin structure stack body 30, and
characterized in that double pin structure stack body 30 is formed of first p-type semiconductor layer 11, i-type amorphous silicon-based photoelectric conversion layer 12, first n-type semiconductor layer 13, second p-type semiconductor layer 21, i-type microcrystalline silicon-based photoelectric conversion layer 22, and second n-type semiconductor layer 23 successively formed on transparent conductive film 2, the concentration of impurity atom determining a conductivity type of first n-type semiconductor layer 13 is not higher than 3×10¹⁹cm⁻³, and the concentration of impurity atom determining a conductivity type of second p-type semiconductor layer 21 is not higher than 5x10¹⁹cm⁻³. By setting the concentration of the impurity atom determining the conductivity type of first n-type semiconductor layer 13 and second p-type semiconductor layer 21 to the above concentration or lower, with the manufacturing method shown in Embodiment 1 to Embodiment 4, introduction of the conductivity-type-determining impurity atoms for first n-type semiconductor layer 13 into another layer (layer other than first n-type semiconductor layer 13) and introduction of the conductivity-type-determining impurity atoms for second p-type semiconductor layer 21 into another layer (layer other than second p-type semiconductor layer 21) are effectively suppressed, and the stack-type silicon-based thin-film photoelectric conversion device of high photoelectric conversion efficiency is obtained.

### (Embodiment 7)

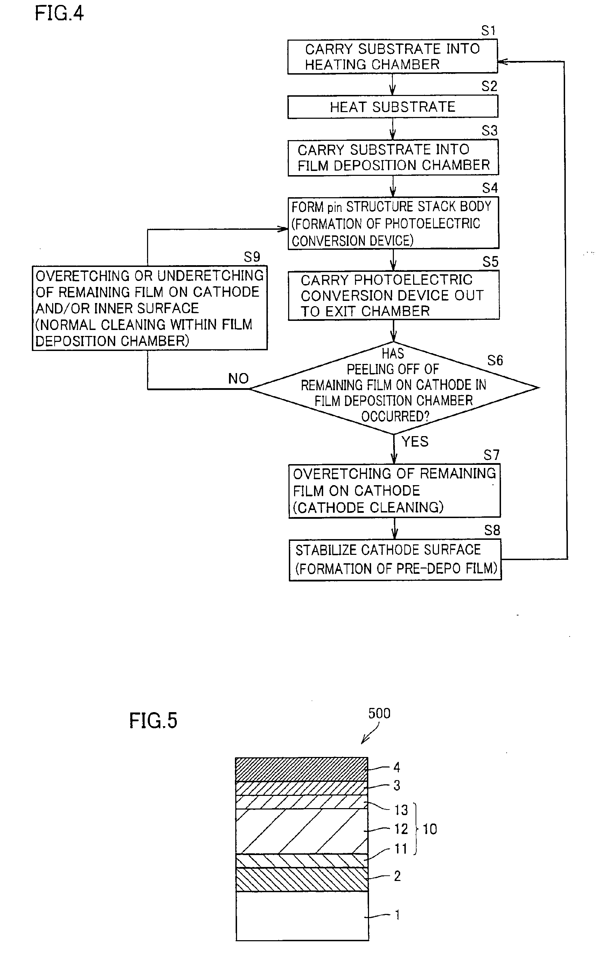

Referring to Figs. 2 and 5, yet another embodiment of the method of manufacturing the silicon-based thin-film photoelectric conversion device according to the present invention is characterized in that the step of forming amorphous pin structure stack body 10 by successively forming, in identical plasma CVD film deposition chamber 222, p-type semiconductor layer 11, i-type amorphous silicon-based photoelectric conversion layer 12 and n-type semiconductor layer 13 on transparent conductive film 2 formed on substrate 1 is included, and p-type
semiconductor layer 11, i-type amorphous silicon-based photoelectric conversion layer 12 and n-type semiconductor layer 13 are formed under such conditions that the film deposition pressure in plasma CVD film deposition chamber 222 is not lower than 200Pa and not higher than 3000Pa and the power density per unit electrode area is not lower than 0.01 W/cm² and not higher than 0.3W/cm².

Namely, referring to Figs. 2 and 5, according to the method of manufacturing the silicon-based thin-film photoelectric conversion device in the present embodiment, amorphous pin structure stack body 10 is formed by successively forming, in identical plasma CVD film deposition chamber 222, p-type semiconductor layer 11, i-type amorphous silicon-based photoelectric conversion layer 12 and n-type semiconductor layer 13 on transparent conductive film 2 formed on substrate 1. Here, p-type semiconductor layer 11, i-type amorphous silicon-based photoelectric conversion layer 12 and n-type semiconductor layer 13 are formed under such conditions that the film deposition pressure in plasma CVD film deposition chamber 222 is not lower than 200Pa and not higher than 3000Pa and the power density per unit electrode area is not lower than 0.01 W/cm² and not higher than 0.3W/cm². In the present embodiment, as shown in Fig. 2, amorphous pin structure stack body 10 is continuously formed in identical plasma CVD film deposition chamber 220 in which a distance between cathode 222 and anode 223 is fixed.

The step of forming pin structure stack body 10 by successively forming, in identical plasma CVD film deposition chamber 222, p-type semiconductor layer 11, i-type amorphous photoelectric conversion layer 12 and n-type semiconductor layer 13 on transparent conductive film 2 formed on substrate 1 in the manufacturing method in the present embodiment shown in Fig. 5 is the same as the step until amorphous pin structure stack body 10 is formed by successively forming first p-type semiconductor layer 11, i-type amorphous silicon-based photoelectric conversion layer 12 and first n-type semiconductor layer 13 on transparent conductive film 2 formed on substrate 1 in the manufacturing method in Embodiment 1 in Fig. 1. Namely, amorphous pin structure stack body 10 (p-type semiconductor layer 11, i-type amorphous silicon-based photoelectric conversion layer 12 and n-type semiconductor layer 13) in the silicon-based thin-film photoelectric conversion device in the present embodiment shown in Fig. 5 is the same as amorphous pin structure stack body 10 (first p-type semiconductor layer 11, i-type amorphous silicon-based photoelectric conversion layer 12 and first n-type semiconductor layer 13) in the silicon-based thin-film photoelectric conversion device in Embodiment 1 shown in Fig. 1. Therefore, formation of amorphous pin structure stack body 10 in the manufacturing method in the present embodiment has the features below, as in formation of amorphous pin structure stack body 10 in the manufacturing method in Embodiment 1.

Specifically, in the present embodiment, utilizing an effect that has not conventionally been conceived, that is, an effect to suppress introduction of an n-type impurity into p-type semiconductor layer 11 and i-type amorphous silicon-based photoelectric conversion layer 12 by setting a higher pressure for forming p-type semiconductor layer 11, i-type amorphous silicon-based photoelectric conversion layer 12 and n-type semiconductor layer 13 and lower power density of cathode 222 as compared with conventional formation conditions for forming amorphous pin structure stack body 10 having i-type amorphous silicon-based photoelectric conversion layer 12 in identical plasma CVD film deposition chamber 220 (such as approximately 100Pa to 120Pa), the silicon-based thin-film photoelectric conversion device attaining high photoelectric conversion efficiency can be manufactured even when amorphous pin structure stack body 10 is continuously formed in identical plasma CVD film deposition chamber 220.

In addition, in the present embodiment, amorphous pin structure stack body 10 can be formed in identical plasma CVD film deposition chamber 220 by successively forming p-type semiconductor layer 11, i-type amorphous silicon-based photoelectric conversion layer 12 and n-type semiconductor layer 13 under the conditions the same as in Embodiment 1, that is, such conditions that the distance between cathode 222 and anode 223 within plasma CVD film deposition chamber 220 is set to 3mm to 20mm, preferably 5mm to 15mm, and further preferably 7mm to 12mm, the film deposition pressure is not lower than 200Pa and not higher than 3000Pa, and the power density per unit electrode area is not lower than 0.01W/cm² and not higher than 0.3W/cm².

P-type semiconductor layer 11 and i-type amorphous silicon-based photoelectric conversion layer 12 obtained under the conditions as above are less likely to be affected by the n-type impurity atoms in the remaining film formed in plasma CVD film deposition chamber 220 in the preceding process for forming n-type semiconductor layer 13, even when amorphous pin structure stack body 10 is repeatedly formed on the next substrate after amorphous pin structure stack body 10 is formed and substrate 1 is taken out.

The film deposition pressure not lower than 200Pa is a pressure condition higher than a conventional condition for forming an amorphous silicon-based semiconductor layer (approximately from 100Pa to 120Pa). By forming p-type semiconductor layer 11 and i-type amorphous silicon-based photoelectric conversion layer 12 at a high film deposition pressure, mean free path (travel distance within the plasma CVD film deposition chamber) of the n-type impurity released from the n-type semiconductor layer that has adhered to cathode 222 and/or inner surface 221 in plasma CVD film deposition chamber 220 before formation of these layers is decreased, and an amount of n-type impurity atoms taken into p-type semiconductor layer 11 and i-type amorphous silicon-based photoelectric conversion layer 12 to be formed can be decreased. In addition, by forming p-type semiconductor layer 11 and i-type amorphous silicon-based photoelectric conversion layer 12 under such formation condition as the film deposition pressure not higher than 3000Pa, a silicon-based semiconductor thin film of a film quality excellent for a thin-film photoelectric conversion device can be formed.

Moreover, by forming p-type semiconductor layer 11 and i-type amorphous silicon-based photoelectric conversion layer 12 at low power density not higher than 0.3W/cm² per unit electrode area, energy of electrons and ions in plasma that collide with cathode 222 can be lowered. As the n-type impurity atoms are expelled from the n-type semiconductor layer that has adhered to cathode 222 by the electrons and ions in the plasma, by lowering the energy thereof, the amount of the n-type impurity atoms taken into p-type semiconductor layer 11 and i-type amorphous silicon-based photoelectric conversion layer 12 to be formed can be decreased. Further, by forming p-type semiconductor layer 11 and i-type amorphous silicon-based photoelectric conversion layer 12 under such formation condition as the power density not lower than 0.01 W/cm², a silicon-based semiconductor thin film of a film quality excellent for a thin-film photoelectric conversion device can be formed.

Consequently, amorphous pin structure stack body 10 can continuously be formed on transparent conductive film 2 on next substrate 1 without performing the step of removing the remaining film formed on cathode 222 and/or inner surface 221 in plasma CVD film deposition chamber 220 and a next silicon-based thin-film photoelectric conversion device can be manufactured.

In addition, by forming i-type amorphous silicon-based photoelectric conversion layer 12 under the formation condition above, an amount of introduction into i-type amorphous silicon-based photoelectric conversion layer 12, of p-type impurity atoms in p-type semiconductor layer 11 that has adhered to cathode 222 and/or inner surface 221 in formation of p-type semiconductor layer 11 is decreased.

By forming the p-type layer, the i-type layer and the n-type layer in this order in amorphous pin structure stack body 10 above, impurity atoms affect less the i-type layer serving as the photoelectric conversion layer, as compared with formation in the order of the n-type layer, the i-type layer and the p-type layer. This may be because, influence of introduction of the n-type impurity atoms (such as phosphorus atoms) into the i-type layer is greater than in the case of introduction of the p-type impurity atoms (such as boron atoms) into the same, and therefore, formation of the n-type layer following formation of the i-type layer affects the i-type layer less than formation of the p-type layer following formation of the i-type layer.

The thickness, the formation conditions and the concentration of the conductivity-type-determining impurity of p-type semiconductor layer 11, i-type amorphous silicon-based photoelectric conversion layer 12 and n-type semiconductor layer 13 in the present embodiment are the same as those of first p-type semiconductor layer 11, i-type amorphous silicon-based photoelectric conversion layer 12 and n-type semiconductor layer 13 in Embodiment 1, respectively.

Specifically, p-type semiconductor layer 11 is formed of an amorphous silicon-based semiconductor or a crystalline silicon-based semiconductor, and formed under such conditions that the film deposition pressure is not lower than 200Pa and not higher than 3000Pa, preferably not lower than 300Pa and not higher than 2000Pa, and further preferably not lower than 400Pa and not higher than 1500Pa. In addition, p-type semiconductor layer 11 is formed under such conditions that the power density per unit electrode area is not lower than 0.01 W/cm² and not higher than 0.3W/cm², preferably not lower than 0.015W/cm² and not higher than 0.2W/cm², and further preferably not lower than 0.02W/cm² and not higher than 0.15W/cm².

In addition, i-type amorphous silicon-based photoelectric conversion layer 12 is formed under such conditions that the film deposition pressure is not lower than 200Pa and not higher than 3000Pa, preferably not lower than 300Pa and not higher than 2000Pa, and further preferably not lower than 400Pa and not higher than 1500Pa. In addition, i-type amorphous silicon-based photoelectric conversion layer 12 is formed under such conditions that the power density per unit electrode area is not lower than 0.01 W/cm² and not higher than 0.3 W/cm², preferably not lower than 0.015 W/cm² and not higher than 0.2W/cm², and further preferably not lower than 0.02W/cm² and not higher than 0.15 W/cm².

Moreover, n-type semiconductor layer 13 can be formed without affecting i-type amorphous silicon-based photoelectric conversion layer 12, by setting the temperature of the underlying base of substrate 1 to a temperature preferably not higher than 250°C. Here, though the conductivity-type-determining impurity atom for n-type semiconductor layer 13 is not particularly limited, phosphorous atom is preferred in view of high doping efficiency and versatility. In addition, the content of phosphorus atoms relative to silicon atoms in the raw material gas is preferably not lower than 0.1 atomic % and more preferably not lower than 0.3 atomic % in view of sufficient doping effect, and preferably not higher than 5 atomic % and more preferably not higher than 3 atomic % in view of avoiding deterioration in film quality.

As amorphous pin structure stack body 10 (that is, p-type semiconductor layer 11, i-type amorphous silicon-based photoelectric conversion layer 12 and n-type semiconductor layer 13) can repeatedly be formed in identical plasma CVD film deposition chamber 220, a silicon-based thin-film photoelectric conversion device 500 having high photoelectric conversion efficiency can be manufactured efficiently at low cost.

In addition, n-type semiconductor layer 13 is desirably formed of an amorphous silicon-based semiconductor or a crystalline silicon-based semiconductor, and formed under such conditions that the film deposition pressure is not lower than 200Pa and not higher than 3000Pa, preferably not lower than 300Pa and not higher than 2000Pa, and further preferably not lower than 400Pa and not higher than 1500Pa. In addition, n-type semiconductor layer 13 is desirably formed under such conditions that the power density per unit electrode area is not lower than 0.01 W/cm² and not higher than 0.3W/cm², preferably not lower than 0.015W/cm² and not higher than 0.2W/cm², and further preferably not lower than 0.02W/cm² and not higher than 0.15W/cm².

N-type semiconductor layer 13 may be formed from any of an amorphous semiconductor and a crystalline semiconductor, however, the crystalline semiconductor is desirable. As a crystal portion included in the crystalline semiconductor is highly efficiently doped with n-type impurity atoms, inclusion of the crystal portion in n-type semiconductor layer 13 can bring about desired conductivity without increasing the concentration of n-type impurity atoms. Therefore, the concentration of the n-type impurity atoms in n-type semiconductor layer 13 can be lowered and diffusion thereof to other layers can be lowered. Namely, in successively forming amorphous pin structure stack body 10 on another substrate 1, as the concentration of the n-type impurity atoms in the n-type semiconductor layer that has adhered to cathode 222 and/or inner surface 221 in plasma CVD film deposition chamber 220 before formation of next p-type semiconductor layer 11 and i-type amorphous silicon-based photoelectric conversion layer 12 is low, an amount of n-type impurity atoms taken into p-type semiconductor layer 11 and i-type amorphous silicon-based photoelectric conversion layer 12 to be formed can be decreased. Silicon-based thin-film photoelectric conversion device 500 having high photoelectric conversion efficiency can thus repeatedly be manufactured.

### (Embodiment 8)

Another embodiment of the method of manufacturing a silicon-based thin-film photoelectric conversion device according to the present invention includes the steps of carrying silicon-based thin-film photoelectric conversion device 500 including amorphous pin structure stack body 10 out of plasma CVD film deposition chamber 220 and removing the remaining film on cathode 222 and/or inner surface 221 in plasma CVD film deposition chamber 220, after the step of forming amorphous pin structure stack body 10 in Embodiment 7 above. Namely, the method of manufacturing the silicon-based thin-film photoelectric conversion device in the present embodiment is characterized in that, after amorphous pin structure stack body 10 is formed, silicon-based thin-film photoelectric conversion device 500 including amorphous pin structure stack body 10 is carried out of plasma CVD film deposition chamber 220 and the remaining film on cathode 222 and/or inner surface 221 in plasma CVD film deposition chamber 220 is removed.

After amorphous pin structure stack body 10 is formed in identical plasma CVD film deposition chamber 220 as shown in Embodiment 7, silicon-based thin-film photoelectric conversion device 500 including amorphous pin structure stack body 10 is carried out, and thereafter the remaining film formed on cathode 222 and/or inner surface 221 in plasma CVD film deposition chamber 220 is removed, so that silicon-based thin-film photoelectric conversion device 500 having excellent quality and performance can repeatedly be manufactured in identical plasma CVD film deposition chamber 220.

Next silicon-based thin-film photoelectric conversion device 500 can also be formed by forming amorphous pin structure stack body 10 in identical plasma CVD film deposition chamber 220 without performing the step of removing the remaining film on cathode 222 and/or inner surface 221 in plasma CVD film deposition chamber 220 using the method shown in Embodiment 7.

In view of prevention of contamination by the remaining film in plasma CVD film deposition chamber 220, however, rather than successively forming amorphous pin structure stack body 10 of next silicon-based thin-film photoelectric conversion device 500 on transparent conductive film 2 on next substrate 1 after formation of one silicon-based thin-film photoelectric conversion device 500, it is preferred to completely remove the remaining film on cathode 222 and/or inner surface 221 in plasma CVD film deposition chamber 220 before formation of amorphous pin structure stack body 10 so as to completely eliminate influence of diffusion of impurity atoms (n-type dopant) in the n-type layer in the remaining film into amorphous pin structure stack body 10 of next silicon-based thin-film photoelectric conversion device 500. Thus, silicon-based thin-film photoelectric conversion device 500 having excellent quality and performance can successively be formed with excellent reproducibility.

Namely, the method of manufacturing the silicon-based thin-film photoelectric conversion device of the present embodiment is characterized by further including the step of removing the remaining film on cathode 222 and/or inner surface 221 in plasma CVD film deposition chamber 220 as the step for eliminating influence of impurity atoms (p-type impurity atoms and n-type impurity atoms) in the p-type layer and the n-type layer in the remaining film in plasma CVD film deposition chamber 220 onto the pin structure stack body at the time of formation of the pin structure stack body to be performed in the next step. With such a step, even if a plurality of photoelectric conversion devices are continuously manufactured in a single chamber system, influence of impurity atoms in the remaining film can be eliminated and introduction of the n-type impurity atoms into the p-type semiconductor layer and the i-type amorphous silicon-based thin-film photoelectric conversion layer in the pin structure stack body can significantly be lowered. Thus, the pin structure stack body having excellent quality and performance can repeatedly be formed and the silicon-based thin-film photoelectric conversion device can be manufactured using the single chamber system. Then, facilities can be simplified as compared with manufacturing facilities based on the in-line system, the multi-chamber system, or combination thereof, and lower cost can be achieved. The cleaning gas used in the step of removing the remaining film in the present embodiment is the same as in Embodiment 2.

### (Embodiment 9)

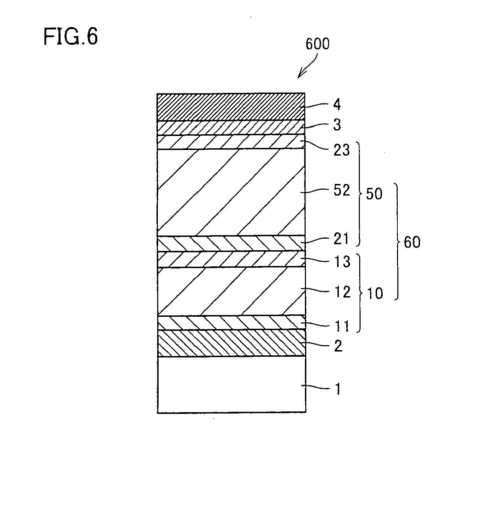

Referring to Figs. 2 and 6, yet another embodiment of the method of manufacturing the silicon-based thin-film photoelectric conversion device according to the present invention is characterized in that the step of forming a double pin structure stack body 60 by successively forming, in identical plasma CVD film deposition chamber 220, first p-type semiconductor layer 11, first i-type amorphous silicon-based photoelectric conversion layer 12, first n-type semiconductor layer 13, second p-type semiconductor layer 21, a second i-type amorphous silicon-based photoelectric conversion layer 52, and second n-type semiconductor layer 23 on transparent conductive film 2 formed on substrate 1 is included, and first p-type semiconductor layer 11, first i-type amorphous silicon-based photoelectric conversion layer 12, first n-type semiconductor layer 13, second p-type semiconductor layer 21, second i-type amorphous silicon-based photoelectric conversion layer 52, and second n-type semiconductor layer 23 are formed under such conditions that the film deposition pressure in plasma CVD film deposition chamber 220 is not lower than 200Pa and not higher than 3000Pa and the power density per unit electrode area is not lower than 0.01 W/cm² and not higher than 0.3W/cm².

Namely, referring to Figs. 2 and 6, according to the method of manufacturing the silicon-based thin-film photoelectric conversion device in the present embodiment, double pin structure stack body 60 is formed by successively forming, in identical plasma CVD film deposition chamber 220, first p-type semiconductor layer 11, first i-type amorphous silicon-based photoelectric conversion layer 12, first n-type semiconductor layer 13, second p-type semiconductor layer 21, second i-type amorphous silicon-based photoelectric conversion layer 52, and second n-type semiconductor layer 23 on transparent conductive film 2 formed on substrate 1. Here, first p-type semiconductor layer 11, first i-type amorphous silicon-based photoelectric conversion layer 12, first n-type semiconductor layer 13, second p-type semiconductor layer 21, second i-type amorphous silicon-based photoelectric conversion layer 52, and second n-type semiconductor layer 23 are formed under such conditions that the film deposition pressure in plasma CVD film deposition chamber 220 is not lower than 200Pa and not higher than 3000Pa and the power density per unit electrode area is not lower than 0.01 W/cm² and not higher than 0.3 W/cm². In the present embodiment, double pin structure stack body 60 is repeatedly formed in identical plasma CVD film deposition chamber 220 in which the distance between cathode 222 and anode 223 is fixed as shown in Fig. 2.

The step of forming amorphous pin structure stack body 10 by successively forming, in identical plasma CVD film deposition chamber 220, first p-type semiconductor layer 11, first i-type amorphous photoelectric conversion layer 12 and first n-type semiconductor layer 13 on transparent conductive film 2 formed on substrate 1 in the manufacturing method in the present embodiment shown in Fig. 6 is the same as the step until amorphous pin structure stack body 10 is formed by successively forming first p-type semiconductor layer 11, i-type amorphous silicon-based photoelectric conversion layer 12 and first n-type semiconductor layer 13 on transparent conductive film 2 formed on substrate 1 in the manufacturing method in Embodiment 1 in Fig. 1 and the step of forming amorphous pin structure stack body 10 by successively forming p-type semiconductor layer 11, i-type amorphous silicon-based photoelectric conversion layer 12 and n-type semiconductor layer 13 on transparent conductive film 2 formed on substrate 1 in the manufacturing method in Embodiment 7 in Fig. 5.

Namely, amorphous pin structure stack body 10 (first p-type semiconductor layer 11, i-type amorphous silicon-based photoelectric conversion layer 12 and second n-type semiconductor layer 13) in a silicon-based thin-film photoelectric conversion device 600 in the present embodiment shown in Fig. 6 is the same as amorphous pin structure stack body 10 (first p-type semiconductor layer 11, i-type amorphous silicon-based photoelectric conversion layer 12 and first n-type semiconductor layer 13) in silicon-based thin-film photoelectric conversion device 100 in Embodiment 1 shown in Fig. 1 and amorphous pin structure stack body 10 (p-type semiconductor layer 11, i-type amorphous silicon-based photoelectric conversion layer 12 and n-type semiconductor layer 13) in silicon-based thin-film photoelectric conversion device 500 in Embodiment 7 shown in Fig. 5.

In addition, in the present embodiment, double pin structure stack body 60 can be formed in identical plasma CVD film deposition chamber 220 by successively forming first p-type semiconductor layer 11, first i-type amorphous silicon-based photoelectric conversion layer 12, first n-type semiconductor layer 13, second p-type semiconductor layer 21, second i-type amorphous silicon-based photoelectric conversion layer 52, and second n-type semiconductor layer 23 under the conditions the same as in Embodiments 1 and 7, that is, such conditions that the distance between cathode 222 and anode 223 within plasma CVD film deposition chamber 220 is set to 3mm to 20mm, preferably 5mm to 15mm, and further preferably 7mm to 12mm, the film deposition pressure is not lower than 200Pa and not higher than 3000Pa, and the power density per unit electrode area is not lower than 0.01 W/cm² and not higher than 0.3 W/cm².

Namely, double pin structure stack body 60 is implemented by forming amorphous pin structure stack body 10 described in Embodiment 7 repeatedly twice under the similar formation conditions, and it is constituted of first amorphous pin structure stack body 10 and a second amorphous pin structure stack body 50. Therefore, second p-type semiconductor layer 21, second i-type amorphous silicon-based photoelectric conversion layer 52, and second n-type semiconductor layer 23 forming amorphous pin stack structure body 52 are the same as first p-type semiconductor layer 11, first i-type amorphous silicon-based photoelectric conversion layer 12, and first n-type semiconductor layer 13 forming amorphous pin structure stack body 10, respectively. Here, in order to achieve matching of currents output from two amorphous pin structure stack bodies 10, 50 connected in series, second i-type amorphous silicon-based photoelectric conversion layer 52 has a thickness greater than the thickness of first i-type amorphous silicon-based photoelectric conversion layer 12. In general, first i-type amorphous silicon-based photoelectric conversion layer 12 has a thickness of approximately several ten nm, while second i-type amorphous silicon-based photoelectric conversion layer 52 has a thickness of approximately from 200 to 400nm.

In the present embodiment, when second amorphous pin structure stack body 50 is formed by successively forming first p-type semiconductor layer 11 and first i-type amorphous silicon-based photoelectric conversion layer 12 under such conditions that the film deposition pressure is not lower than 200Pa and not higher than 3000Pa and
the power density per unit electrode area is not lower than 0.01 W/cm² and not higher than 0.3W/cm², substrate 1 is thereafter changed, and first amorphous pin structure stack body 10 is repeatedly formed on that substrate, first p-type semiconductor layer 11 and first i-type amorphous silicon-based photoelectric conversion layer 12 obtained under the formation conditions as above are less likely to be affected by the n-type impurity atoms in the remaining film formed in plasma CVD film deposition chamber 220 in the preceding process for forming second n-type semiconductor layer 23.

The film deposition pressure not lower than 200Pa is a pressure condition higher than a general condition for forming an amorphous silicon-based semiconductor layer. By forming first p-type semiconductor layer 11 and first i-type amorphous silicon-based photoelectric conversion layer 12 at a high film deposition pressure, mean free path (travel distance within the plasma CVD film deposition chamber) of the n-type impurity atoms released from second n-type semiconductor layer 23 that has adhered to cathode 222 and/or inner surface 221 in plasma CVD film deposition chamber 220 before formation of these layers is decreased, and an amount of n-type impurity atoms taken into first p-type semiconductor layer 11 and first i-type amorphous silicon-based photoelectric conversion layer 12 to be formed can be decreased. In addition, by forming first p-type semiconductor layer 11 and first i-type amorphous silicon-based photoelectric conversion layer 12 under such formation condition as the film deposition pressure not higher than 3000Pa, a silicon-based semiconductor thin film of a film quality excellent for a thin-film photoelectric conversion device can be formed.

Moreover, by forming first p-type semiconductor layer 11 and first i-type amorphous silicon-based photoelectric conversion layer 12 at low power density not higher than 0.3W/cm² per unit electrode area, energy of electrons and ions in plasma that collide with cathode 222 can be lowered. As the n-type impurity atoms are expelled from second n-type semiconductor layer 23 that has adhered to cathode 222 by the electrons and ions in the plasma, by lowering the energy thereof, the amount of the n-type impurity atoms taken into first p-type semiconductor layer 11 and first i-type amorphous silicon-based photoelectric conversion layer 51 to be formed can be decreased. Further, by forming first p-type semiconductor layer 11 and first i-type amorphous silicon-based photoelectric conversion layer 12 under such formation condition as the power density not lower than 0.01 W/cm², a silicon-based semiconductor thin film of a film quality excellent for a thin-film photoelectric conversion device can be formed.

Consequently, double pin structure stack body 60 can continuously be formed on transparent conductive film 2 on next substrate 1 without performing the step of removing the remaining film of second n-type semiconductor layer 23 formed on cathode 222 and/or inner surface 221 in plasma CVD film deposition chamber 220 and next stack-type silicon-based thin-film photoelectric conversion device 600 can be manufactured.

In addition, by forming first i-type amorphous silicon-based photoelectric conversion layer 12 under the condition above, an amount of introduction into first i-type amorphous silicon-based photoelectric conversion layer 12, of p-type impurity atoms in first p-type semiconductor layer 11 that has adhered to cathode 222 and/or inner surface 221 in formation of first p-type semiconductor layer 11 can be decreased. Namely, influence of the p-type impurity in first p-type semiconductor layer 11 onto first i-type amorphous silicon-based photoelectric conversion layer 12 can be lowered.

First n-type semiconductor layer 13 may be formed from any of an amorphous semiconductor and a crystalline semiconductor, however, the crystalline semiconductor is desirable. As a crystal portion included in the crystalline semiconductor is highly efficiently doped with n-type impurity atoms, inclusion of the crystal portion in the n-type semiconductor layer can bring about desired conductivity without increasing the concentration of n-type impurity atoms. Therefore, the concentration of the n-type impurity in first n-type semiconductor layer 13 can be lowered and diffusion thereof to other layers can be mitigated. Namely, in successively forming second amorphous pin structure stack body 52 after formation of first n-type semiconductor layer 13, as the concentration of the n-type impurity atoms in first n-type semiconductor layer 13 that has adhered to cathode 222 and/or inner surface 221 in plasma CVD film deposition chamber 220 before formation of second p-type semiconductor layer 21 and second i-type amorphous silicon-based photoelectric conversion layer 52 is low, an amount of n-type impurity atoms taken into second p-type semiconductor layer 21 and second i-type amorphous silicon-based photoelectric conversion layer 52 to be formed can be decreased.

In addition, in the present embodiment, second p-type semiconductor layer 21 and second i-type amorphous silicon-based photoelectric conversion layer 52 are successively formed under such conditions that the film deposition pressure is not lower than 200Pa and not higher than 3000Pa and the power density per unit electrode area is not lower than 0.01W/cm² and not higher than 0.3 W/cm². When second p-type semiconductor layer 21 and second i-type amorphous silicon-based photoelectric conversion layer 52 are formed under such formation conditions, influence of n-type impurity atoms in the remaining film formed in plasma CVD film deposition chamber 220 in formation of first n-type semiconductor layer 13 is less likely.

The film deposition pressure not lower than 200Pa is a pressure condition higher than a general condition for forming an amorphous silicon-based semiconductor layer. By forming second p-type semiconductor layer 21 and second i-type amorphous silicon-based photoelectric conversion layer 52 at a high film deposition pressure, mean free path (travel distance within the plasma CVD film deposition chamber) of the n-type impurity released from first n-type semiconductor layer 13 that has adhered to cathode 222 and/or inner surface 221 in plasma CVD film deposition chamber 220 before formation of these layers is decreased, and an amount of n-type impurity atoms taken into second p-type semiconductor layer 21 and second i-type amorphous silicon-based photoelectric conversion layer 52 to be formed can be decreased. In addition, by forming second p-type semiconductor layer 21 and second i-type amorphous silicon-based photoelectric conversion layer 52 under such formation condition as the film deposition pressure not higher than 3000Pa, a silicon-based semiconductor thin film of a film quality excellent for a thin-film photoelectric conversion device can be formed.

Moreover, by forming second p-type semiconductor layer 21 and second i-type amorphous silicon-based photoelectric conversion layer 52 at low power density not higher than 0.3W/cm² per unit electrode area, energy of electrons and ions in plasma that collide with cathode 222 can be lowered. As the n-type impurity atoms are expelled from first n-type semiconductor layer 13 that has adhered to cathode 222 by the electrons and ions in the plasma, by lowering the energy thereof, the amount of the n-type impurity atoms taken into second p-type semiconductor layer 21 and second i-type amorphous silicon-based photoelectric conversion layer 52 to be formed can be decreased. Further, by forming second p-type semiconductor layer 21 and second i-type amorphous silicon-based photoelectric conversion layer 52 under such formation condition as the power density not lower than 0.01 W/cm², a silicon-based semiconductor thin film of a film quality excellent for a thin-film photoelectric conversion device can be formed.

In addition, by forming second i-type amorphous silicon-based photoelectric conversion layer 52 under the condition above, an amount of introduction into second i-type amorphous silicon-based photoelectric conversion layer 52, of p-type impurity atoms in second p-type semiconductor layer 21 that has adhered to cathode 222 and/or inner surface 221 in formation of second p-type semiconductor layer 21 can be decreased.

Second n-type semiconductor layer 23 may be formed from any of an amorphous semiconductor and a crystalline semiconductor, however, the crystalline semiconductor is desirable. As a crystal portion included in the crystalline semiconductor is highly efficiently doped with n-type impurity atoms, inclusion of the crystal portion in the n-type semiconductor layer can bring about desired conductivity without increasing the concentration of the n-type impurity atoms. Therefore, the concentration of the n-type impurity in second n-type semiconductor layer 23 can be lowered and diffusion thereof to other layers can be mitigated. Namely, in successively forming double pin structure stack body 60 on another substrate 1, as the concentration of the n-type impurity atoms in second n-type semiconductor layer 23 that has adhered to cathode 222 and/or inner surface 221 in plasma CVD film deposition chamber 220 before formation of next first p-type semiconductor layer 11 and first i-type amorphous silicon-based photoelectric conversion layer 12 is low, an amount of n-type impurity atoms taken into first p-type semiconductor layer 11 and first i-type amorphous silicon-based photoelectric conversion layer 12 to be formed can be decreased. Stack-type silicon-based thin-film photoelectric conversion device 600 having high photoelectric conversion efficiency can thus repeatedly be manufactured.

### (Embodiment 10)

Yet another embodiment of the method of manufacturing a silicon-based thin-film photoelectric conversion device according to the present invention includes the steps of carrying silicon-based thin-film photoelectric conversion device 600 including double pin structure stack body 60 out of plasma CVD film deposition chamber 220 and removing the remaining film on cathode 222 and/or inner surface 221 in plasma CVD film deposition chamber 220, after the step of forming double pin structure stack body 60 in Embodiment 9 above. Namely, the method of manufacturing the silicon-based thin-film photoelectric conversion device in the present embodiment is characterized in that, after double pin structure stack body 60 is formed, silicon-based thin-film photoelectric conversion device 600 including double pin structure stack body 60 is carried out of plasma CVD film deposition chamber 220 and the remaining film on cathode 222 and/or inner surface 221 in plasma CVD film deposition chamber 220 is removed.

After double pin structure stack body 60 is formed in identical plasma CVD film deposition chamber 220 as shown in Embodiment 9, silicon-based thin-film photoelectric conversion device 600 including double pin structure stack body 60 is carried out, and thereafter the remaining film formed on cathode 222 and/or inner surface 221 in plasma CVD film deposition chamber 220 is removed, so that stack-type silicon-based thin-film photoelectric conversion device 600 having excellent quality and performance can repeatedly be manufactured in identical plasma CVD film deposition chamber 220.

Next stack-type silicon-based thin-film photoelectric conversion device 600 can also be formed by forming double pin structure stack body 60 in identical plasma CVD film deposition chamber 220 without performing the step of removing the remaining film on cathode 222 and/or inner surface 221 in plasma CVD film deposition chamber 220, using the method shown in Embodiment 9.

In view of prevention of contamination by the remaining film in plasma CVD film deposition chamber 220, however, rather than successively forming double pin structure stack body 60 of next stack-type silicon-based thin-film photoelectric conversion device 600 on transparent conductive film 2 on next substrate 1 after formation of one stack-type silicon-based thin-film photoelectric conversion device 600, it is preferred to completely remove the remaining film on cathode 222 and/or inner surface 221 in plasma CVD film deposition chamber 220 before formation of double pin structure stack body 60 so as to completely eliminate influence of diffusion of impurity atoms (n-type dopant) in the n-type layer in the remaining film into amorphous pin structure stack body 60 of next stack-type silicon-based thin-film photoelectric conversion device 600. Thus, stack-type silicon-based thin-film photoelectric conversion device 600 having excellent quality and performance can successively be formed with excellent reproducibility.

Namely, the method of manufacturing the silicon-based thin-film photoelectric conversion device of the present embodiment is characterized by further including the step of removing the remaining film on cathode 222 and/or inner surface 221 in plasma CVD film deposition chamber 220 as the step for eliminating influence of impurity atoms (p-type impurity atoms and n-type impurity atoms) in the p-type layer and the n-type layer in the remaining film in plasma CVD film deposition chamber 220 onto double pin structure stack body 60 at the time of formation of double pin structure stack body 60 to be performed in the next step. With such a step, even if a plurality of photoelectric conversion devices are continuously manufactured in a single chamber system, influence of impurity atoms in the remaining film can be eliminated and introduction of the n-type impurity atoms into first and second p-type semiconductor layers 11 and 21 and first and second i-type amorphous silicon-based thin-film photoelectric conversion layers 12 and 52 in double pin structure stack body 60 can significantly be lowered. Thus, the double pin structure stack body having excellent quality and performance can repeatedly be formed and the stack-type silicon-based thin-film photoelectric conversion device can be manufactured using the single chamber system. Then, facilities can be simplified as compared with manufacturing facilities based on the in-line system, the multi-chamber system, or combination thereof, and lower cost can be achieved. The cleaning gas used in the step of removing the remaining film in the present embodiment is the same as in Embodiment 2 and Embodiment 8.

### (Embodiment 11)

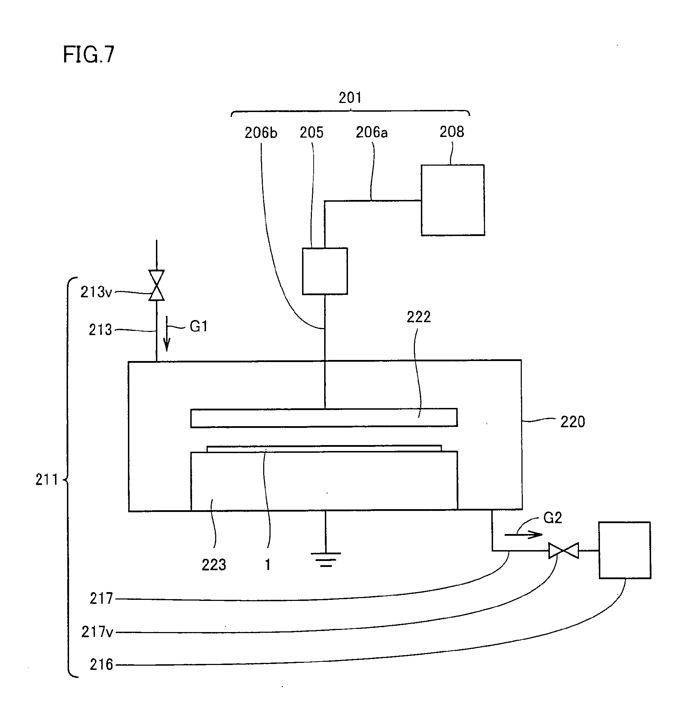

Referring to Fig. 7, one embodiment of an apparatus for manufacturing a silicon-based thin-film photoelectric conversion device according to the present invention is an apparatus for manufacturing a silicon-based thin-film photoelectric conversion device used for the manufacturing method in Embodiment 1 (see Fig. 1), Embodiment 7 (see Fig. 5), Embodiment (see Fig. 6), or the like, and the apparatus for manufacturing the silicon-based thin-film photoelectric conversion device includes plasma CVD film deposition chamber 220 where cathode 222 and anode 223 are arranged, a gas pressure regulating portion 211 regulating a gas pressure within plasma CVD film deposition chamber 220; and an electric power supply portion 201 supplying electric power to cathode 222, the distance between cathode 222 and anode 223 is not smaller than 3mm and not larger than 20mm, gas pressure regulating portion 211 is capable of controlling a gas pressure within CVD film deposition chamber 220 in a range from at least 200Pa to at most 3000Pa, and electric power supply portion 201 is capable of controlling the power density per unit area of the cathode in a range from at least 0.01 W/cm² to at most 0.3 W/cm². In Fig. 7, an arrow G1 indicates a flow of the gas introduced into plasma CVD film deposition chamber 220, while an arrow G2 indicates a flow of the gas exhausted from plasma CVD film deposition chamber 220.

Referring to Fig. 7, for example, the apparatus for manufacturing the silicon-based thin-film photoelectric conversion device in the present embodiment is an apparatus for manufacturing a semiconductor layer with a plasma CVD method, having such a parallel plate electrode structure that cathode 222 and anode 223 are arranged opposed to each other in parallel in plasma CVD film deposition chamber 220 that can hermetically be sealed. Here, the distance between cathode 222 and anode 223 is set, for example, to 3mm to 20mm, preferably 5mm to 15mm, and more preferably 7mm to 12mm. Both electrodes of cathode 222 and anode 223 are fixed so that the distance therebetween is constant or variable. In view of higher accuracy of the distance between the electrodes and smaller size of the apparatus, the distance between the electrodes is preferably fixed to a constant value.

In plasma CVD film deposition chamber 220, a gas introduction pipe 213 provided with a pressure regulating valve 213v, a gas exhaust pipe 217 provided with a pressure regulating valve 217v, and a gas exhaust apparatus 216 (such as a gas exhaust pump) that constitute gas pressure regulating portion 211 are arranged.

The diluent gas, the raw material gas, the doping gas, or the like is introduced into plasma CVD film deposition chamber 220 through gas introduction pipe 213. A gas containing a hydrogen gas is employed as the diluent gas, a silane-based gas, a methane gas, a germane gas, or the like is employed as the raw material gas, a diborane gas or the like for doping with the p-type impurity atoms is employed as the p-type impurity atom doping gas, and a phosphine gas or the like for doping with the n-type impurity atoms is employed.

In addition, the gas within plasma CVD film deposition chamber 220 is exhausted through gas exhaust pipe 217 by means of gas exhaust apparatus 216. Here, by adjusting pressure regulating valves 213v, 216v and gas exhaust apparatus 216, the gas pressure in plasma CVD film deposition chamber 220 can be regulated. Here, gas exhaust apparatus 216 may be capable of high-vacuum exhaust such that the gas pressure in plasma CVD film deposition chamber 220 is set to a background pressure as high as approximately 1.0 × 10⁻⁴ Pa, however, in view of simplification of the apparatus, lower cost and improved throughput, an apparatus capable of exhaust to a background pressure of approximately 0.1Pa is desirable.

As the manufacturing apparatus in the present embodiment includes gas pressure regulating portion 201 capable of controlling the gas pressure in plasma CVD film deposition chamber 220 in a range from at least 200Pa to at most 3000Pa, preferably from at least 300Pa to at most 2000Pa, and further preferably from at least 400Pa to at most 1500Pa, the pin structure stack body in which introduction of impurity atoms is less likely can be formed, and the silicon-based thin-film photoelectric conversion device having high conversion efficiency can be manufactured efficiently at low cost.

In addition, an electric power output portion 208, am impedance matching circuit 205, and electric power supply lines 206a, 206b supplying electric power generated in electric power output portion 208 to cathode 222 via impedance circuit 205 that constitute electric power supply portion 201 are arranged outside plasma CVD film deposition chamber 220. Here, electric power supply line 206a is connected to electric power output portion 208 and one end of impedance circuit 205, while electric power supply line 206b is connected to the other end of impedance circuit 205 and cathode 222.

Electric power output portion 208 may provide any of CW (continuous wave) AC output and pulse-modulated (ON-OFF controlled) AC output. The AC power output from electric power output portion 208 generally has a frequency of 13.56MHz, however, the frequency is not limited thereto, and a frequency in a band from several kHz to VHF and in a microwave band may be employed.

Meanwhile, anode 223 is electrically connected to ground, and substrate 1 on which the transparent conductive film is formed is placed on anode 223. Though substrate 1 may be placed on cathode 222, it is generally provided on anode 223, in order to mitigate lowering in film quality due to damage caused by ions in plasma. Cathode 222 is supplied with electric power from electric power output portion 208 through electric power supply line 206a, impedance matching circuit 205 and electric power supply line 206b.

As the manufacturing apparatus in the present embodiment includes electric power supply portion 201 capable of controlling the power density per unit electrode area of cathode 222 in a range from at least 0.01 W/cm² to at most 0.3W/cm², preferably from at least 0.015W/cm² to at most 0.2W/cm², and further preferably from at least 0.02W/cm² to at most 0.15W/cm², the pin structure stack body in which introduction of impurity atoms is less likely can be formed and the silicon-based thin-film photoelectric conversion device having high conversion efficiency can be manufactured efficiently at low cost.

### Examples

### (Example 1)

In the present example, the stack-type silicon-based thin-film photoelectric conversion device is repeatedly manufactured by repeatedly forming double pin structure stack body 30 (amorphous pin structure stack body 10 and microcrystalline pin structure stack body 20) shown in Fig. 1 in identical plasma CVD film deposition chamber 220 shown in Fig. 2.

An amorphous silicon layer serving as first p-type semiconductor layer 11 and having a thickness of 10nm (boron atom concentration of 3×10¹⁹cm⁻³), an amorphous silicon layer serving as i-type amorphous silicon-based photoelectric conversion layer 12 and having a thickness of 0.5µm, an amorphous silicon layer serving as first n-type semiconductor layer 13 and having a thickness of 30nm (phosphorus atom concentration of 2×10¹⁹cm⁻³, nitrogen atom concentration of 1×10¹⁸cm⁻³, and oxygen atom concentration of 5×10¹⁹cm⁻³), a microcrystalline silicon layer serving as second p-type semiconductor layer 21 and having a thickness of 30nm (boron atom concentration of 3×10¹⁹cm⁻³, nitrogen atom concentration of 1×10¹⁸cm⁻³, and oxygen atom concentration of 5×10¹⁹cm⁻³), a microcrystalline silicon layer serving as i-type microcrystalline silicon-based photoelectric conversion layer 22 and having a thickness of 3µm, and a microcrystalline silicon layer serving as second n-type semiconductor layer 23 and having a thickness of 30nm (phosphorus atom concentration of 3x10¹⁹cm⁻³) are formed on transparent conductive film 2 implemented by an SnO₂ film having a thickness of 1 µm and formed on substrate 1 formed from glass of a thickness of 4mm. Thereafter, a ZnO layer serving as conductive film 3 and having a thickness of 0.05µm and an Ag electrode serving as the metal electrode and having a thickness of 0.1 µm are formed.

Initially, the amorphous silicon layer serving as first p-type semiconductor layer 11 and having a thickness of 10nm was formed on glass substrate 1 on which the Sn0₂ film (transparent conductive film 2) having irregularities was formed, under such conditions that the pressure in plasma CVD film deposition chamber 220 was set to 500Pa and the power density per unit electrode area of the cathode was set to 0.05 W/cm².

Thereafter, the amorphous silicon layer serving as i-type amorphous silicon-based photoelectric conversion layer 12 and having a thickness of 0.5µm was formed on first p-type semiconductor layer 11 under such conditions that the pressure in plasma CVD film deposition chamber 220 was set to 500Pa and the power density per unit electrode area of the cathode was set to 0.07W/cm².

Thereafter, the amorphous silicon layer serving as first n-type semiconductor layer 13 and having a thickness of 30nm was formed on i-type amorphous silicon-based photoelectric conversion layer 12 under such conditions that the pressure in plasma CVD film deposition chamber 220 was set to 500Pa and the power density per unit electrode area of the cathode was set to 0.05W/cm².

Thereafter, the microcrystalline silicon layer serving as second p-type semiconductor layer 21 and having a thickness of 30nm was formed on first n-type semiconductor layer 13 under such conditions that the pressure in plasma CVD film deposition chamber 220 was set to 800Pa and the power density per unit electrode area of the cathode was set to 0.08W/cm².

Thereafter, the microcrystalline silicon layer serving as i-type microcrystalline silicon-based photoelectric conversion layer 22 and having a thickness of 3µm was formed on second p-type semiconductor layer 21 under such conditions that the pressure in plasma CVD film deposition chamber 220 was set to 800Pa and the power density per unit electrode area of the cathode was set to 0.10W/cm².

Thereafter, the microcrystalline silicon layer serving as second n-type semiconductor layer 23 and having a thickness of 30nm was formed on i-type microcrystalline silicon-based photoelectric conversion layer 22 under such conditions that the pressure in plasma CVD film deposition chamber 220 was set to 800Pa and the power density per unit electrode area of the cathode was set to 0.08W/cm².

Thereafter, the ZnO layer serving as conductive film 3 and having a thickness of 0.05µm and the Ag electrode serving as the metal electrode and having a thickness of 0.1 µm were formed with sputtering, to manufacture the tandem-type silicon thin-film photoelectric conversion device which is the stack-type silicon thin-film photoelectric conversion device.

The photoelectric conversion efficiency of the obtained tandem-type silicon thin-film photoelectric conversion device was measured and the result was 13.6%.

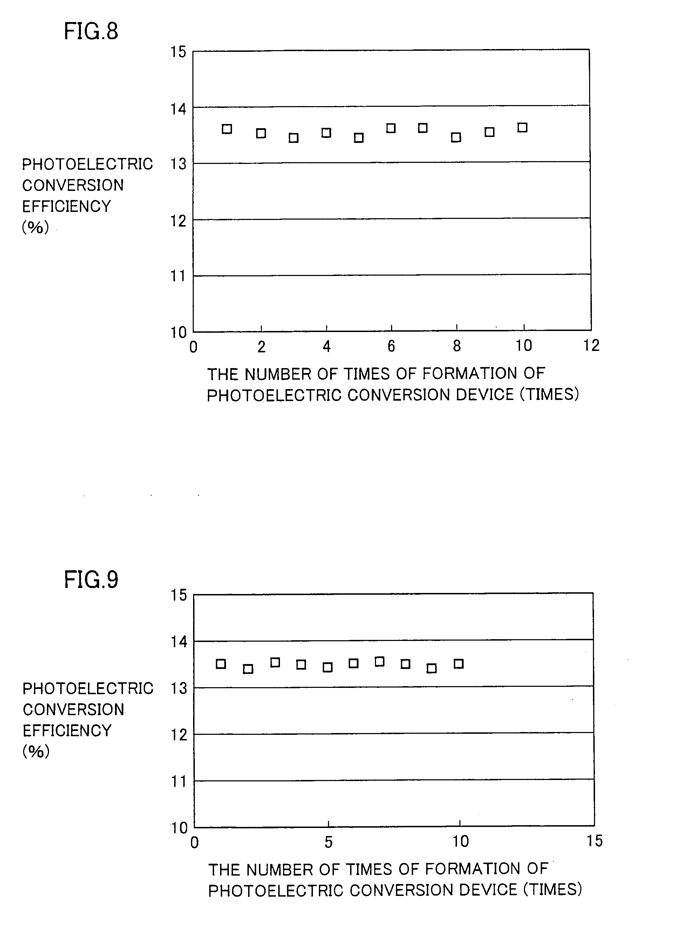

Thereafter, second double pin structure stack body 30 was formed in identical plasma CVD film deposition chamber 220 under the conditions the same as above, to manufacture the stack-type silicon thin-film photoelectric conversion device with the similar method. The photoelectric conversion efficiency of the obtained second stack-type silicon thin-film photoelectric conversion device was measured and the result was 13.5%. Thus, ten tandem-type silicon thin-film photoelectric conversion devices were successively manufactured. The photoelectric conversion efficiencies of the third, fourth, fifth, sixth, seventh, eighth, ninth, and tenth tandem-type silicon thin-film photoelectric conversion devices were 13.4%, 13.5%, 13.4%, 13.6%, 13.6%, 13.4%, 13.5%, and 13.6%, respectively. The results are shown in Fig. 8.

As can clearly be seen also from Fig. 8, no significant change in the photoelectric conversion efficiency of the first to tenth tandem-type photoelectric conversion devices was observed, and the stack-type silicon thin-film photoelectric conversion device having excellent characteristics could be manufactured in a stable manner.

### (Example 2)

The tandem-type silicon-based photoelectric conversion device which is the stack-type silicon thin-film photoelectric conversion device was obtained by continuously (repeatedly) forming double pin structure stack body 30 (amorphous pin structure stack body 10 and microcrystalline pin structure stack body 20) shown in Fig. 1 in identical film deposition chamber 220 in plasma CVD apparatus 200 shown in Fig. 2 in accordance with S1 to S5 shown in Fig. 4.

Here, in the tandem-type photoelectric conversion device in the present example, a glass substrate having a thickness of 4mm was employed as substrate 1. An SnO₂ film serving as transparent conductive film 2 and having a thickness of 1 µm, an amorphous silicon layer serving as first p-type semiconductor layer 11 and having a thickness of 10nm (boron atom concentration of 3x10¹⁹cm⁻³), an amorphous silicon layer serving as i-type amorphous silicon-based photoelectric conversion layer 12 and having a thickness of 0.5µm, an amorphous silicon layer serving as first n-type semiconductor layer 13 and having a thickness of 30nm (phosphorus atom concentration of 2×10¹⁹cm⁻³, nitrogen atom concentration of 1×10¹⁸cm⁻³, and oxygen atom concentration of 5×10¹⁹cm⁻³), a microcrystalline silicon layer serving as second p-type semiconductor layer 21 and having a thickness of 30nm (boron atom concentration of 3×10¹⁹cm⁻³, nitrogen atom concentration of 1×10¹⁸cm⁻³, and oxygen atom concentration of 5×10¹⁹cm⁻³), a microcrystalline silicon layer serving as i-type microcrystalline silicon-based photoelectric conversion layer 22 and having a thickness of 3µm, a microcrystalline silicon layer serving as second n-type semiconductor layer 23 and having a thickness of 30nm (phosphorus atom concentration of 3×10¹⁹cm⁻³), a ZnO layer serving as conductive film 3 and having a thickness of 0.05µm, and an Ag electrode serving as the metal electrode and having a thickness of 0.1 µm are successively formed on substrate 1.

The photoelectric conversion efficiency of the obtained tandem-type photoelectric conversion device was measured and the result was 13.5%. Thereafter, the remaining film formed in film deposition chamber 220 was removed by underetching the remaining film from the surface layer thereof to a depth comparable to 90% of the thickness of the i-type layer closest to the cathode and the inner surface in the film deposition chamber, and thereafter, the second tandem-type photoelectric conversion device including double pin structure stack body 30 was formed under the conditions the same as above. The photoelectric conversion efficiency of the obtained second tandem-type photoelectric conversion device was measured and the result was 13.4%. Thus, ten tandem-type photoelectric conversion devices were successively obtained. The photoelectric conversion efficiencies of the third, fourth, fifth, sixth, seventh, eighth, ninth, and tenth tandem-type photoelectric conversion devices were 13.5%, 13.5%, 13.4%, 13.5%, 13.5%, 13.5%, 13.4%, and 13.5%, respectively. The results are shown in Fig. 9.

As can clearly be seen also from Fig. 9, the photoelectric conversion efficiency of the first to tenth tandem-type photoelectric conversion devices was substantially constant. In other words, noticeable change in the characteristic was not observed even after formation 10 times. In addition, yield was 100% after any number of times of formation, and excellent.

It was found from the results of the present example that, in repeatedly forming double pin structure stack body 30 in identical plasma film deposition chamber 220, even when double pin structure stack body 30 is formed after double pin structure stack body 30 was formed and the remaining film formed in film deposition chamber 220 was etched, the characteristic of the tandem-type (stack-type) photoelectric conversion device including double pin structure stack body 30 was not lowered and excellent yield was achieved. As yield is not lowered even after etching, frequency of maintenance of the apparatus can be lowered.

### (Example 3)

In the present example, the silicon-based thin-film photoelectric conversion device in which amorphous pin structure stack body 10 shown in Fig. 5 is formed in identical plasma CVD film deposition chamber 220 shown in Fig. 2 is repeatedly manufactured.

An amorphous silicon layer serving as p-type semiconductor layer 11 and having a thickness of 10nm (boron atom concentration of 3×10¹⁹cm⁻³), an amorphous silicon layer serving as i-type amorphous silicon-based photoelectric conversion layer 12 and having a thickness of 0.3µm, and an amorphous silicon layer serving as n-type semiconductor layer 13 and having a thickness of 30mn (phosphorus atom concentration of 2×10¹⁹cm⁻³, nitrogen atom concentration of 1×10¹⁸cm⁻³, and oxygen atom concentration of 5 × 10¹⁹cm⁻³) are formed on transparent conductive film 2 implemented by an SnO₂ film having a thickness of 1 µm and formed on substrate 1 formed from glass of a thickness of 4mm. Thereafter, a ZnO layer serving as conductive film 3 and having a thickness of 0.05µm and an Ag electrode serving as the metal electrode and having a thickness of 0.1 µm are formed.

Initially, the amorphous silicon layer serving as p-type semiconductor layer 11 and having a thickness of 10nm was formed on glass substrate 1 on which the SnO₂ film (transparent conductive film 2) having irregularities was formed, under such conditions that the pressure in plasma CVD film deposition chamber 220 was set to 500Pa and the power density per unit electrode area of the cathode was set to 0.05W/cm².

Thereafter, the amorphous silicon layer serving as i-type amorphous silicon-based photoelectric conversion layer 12 and having a thickness of 0.3µm was formed on p-type semiconductor layer 11 under such conditions that the pressure in plasma CVD film deposition chamber 220 was set to 500Pa and the power density per unit electrode area of the cathode was set to 0.07W/cm².

Thereafter, the amorphous silicon layer serving as n-type semiconductor layer 13 and having a thickness of 30nm was formed on i-type amorphous silicon-based photoelectric conversion layer 12 under such conditions that the pressure in plasma CVD film deposition chamber 220 was set to 500Pa and the power density per unit electrode area of the cathode was set to 0.05W/cm².

Thereafter, the ZnO layer serving as conductive film 3 and having a thickness of 0.05µm and the Ag electrode serving as the metal electrode and having a thickness of 0.1µm were formed with sputtering, to manufacture the stack-type silicon thin-film photoelectric conversion device.

The photoelectric conversion efficiency of the obtained stack-type silicon thin-film photoelectric conversion device was measured and the result was 9.9%.

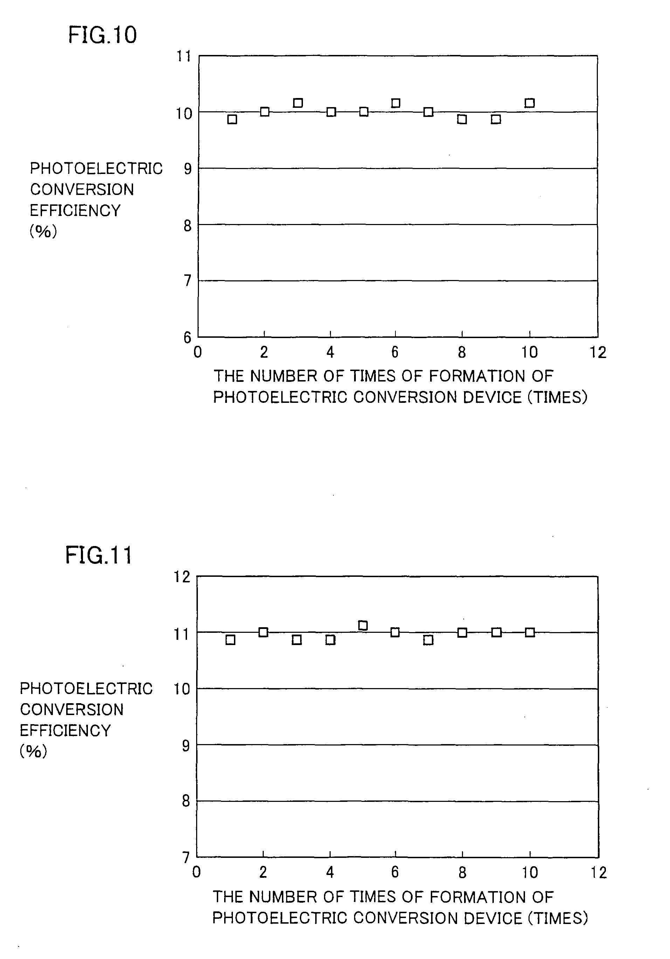

Thereafter, second amorphous pin structure stack body 10 was formed in identical plasma CVD film deposition chamber 220 under the conditions the same as above, to manufacture the silicon thin-film photoelectric conversion device with the similar method. The photoelectric conversion efficiency of the obtained second silicon thin-film photoelectric conversion device was measured and the result was 10.0%. Thus, ten silicon thin-film photoelectric conversion devices were successively manufactured. The photoelectric conversion efficiencies of the third, fourth, fifth, sixth, seventh, eighth, ninth, and tenth silicon thin-film photoelectric conversion devices were 10.1 %, 10.0%, 10.0%, 10.1%, 10.0%, 9.9%, 9.9%, and 10.1 %, respectively. The results are shown in Fig. 10.

As can clearly be seen also from Fig. 10, no significant change in the photoelectric conversion efficiency of the first to tenth silicon thin-film photoelectric conversion devices was observed, and the silicon thin-film photoelectric conversion device having excellent characteristics could be manufactured in a stable manner.

### (Example 4)

In the present example, the stack-type silicon-based thin-film photoelectric conversion device in which double pin structure stack body 60 (first amorphous pin structure stack body 10 and second amorphous pin structure stack body 50) shown in Fig. 6 is formed in identical plasma CVD film deposition chamber 220 shown in Fig. 2 is repeatedly manufactured.

An amorphous silicon layer serving as first p-type semiconductor layer 11 and having a thickness of 10nm (boron atom concentration of 3×10¹⁹cm⁻³), an amorphous silicon layer serving as first i-type amorphous silicon-based photoelectric conversion layer 12 and having a thickness of 0.07µm, and an amorphous silicon layer serving as first n-type semiconductor layer 13 and having a thickness of 30nm (phosphorus atom concentration of 2×10¹⁹cm⁻³, nitrogen atom concentration of 1 ×10¹⁸cm⁻³, and oxygen atom concentration of 5×10¹⁹cm⁻³) are formed on transparent conductive film 2 implemented by an Sn0₂ film having a thickness of 1µm and formed on substrate 1 formed from glass of a thickness of 4mm, to implement first amorphous pin structure stack body 53, and thereafter, an amorphous silicon layer serving as second p-type semiconductor layer 21 and having a thickness of 10nm (boron atom concentration of 3×10¹⁹cm⁻³), an amorphous silicon layer serving as second i-type amorphous silicon-based photoelectric conversion layer 52 and having a thickness of 0.3µm, and an amorphous silicon layer serving as second n-type semiconductor layer 23 and having a thickness of 30nm (phosphorus atom concentration of 2×10¹⁹cm⁻³, nitrogen atom concentration of 1×10¹⁸cm⁻³, and oxygen atom concentration of 5×10¹⁹cm⁻³) are formed, to implement second amorphous pin structure stack body 54. Thereafter, a ZnO layer serving as conductive film 3 and having a thickness of 0.05µm and an Ag electrode serving as metal electrode 4 and having a thickness of 0.1µm are formed.

Initially, the amorphous silicon layer serving as first p-type semiconductor layer 11 and having a thickness of 10nm was formed on glass substrate 1 on which the SnO₂ film (transparent conductive film 2) having irregularities was formed, under such conditions that the pressure in plasma CVD film deposition chamber 220 was set to 500Pa and the power density per unit electrode area of the cathode was set to 0.05 W/cm². Thereafter, the amorphous silicon layer serving as first i-type amorphous silicon-based photoelectric conversion layer 12 and having a thickness of 0.07µm was formed on first p-type semiconductor layer 11 under such conditions that the pressure in plasma CVD film deposition chamber 220 was set to 500Pa and the power density per unit electrode area of the cathode was set to 0.07W/cm².

Thereafter, the amorphous silicon layer serving as first n-type semiconductor layer 13 and having a thickness of 30nm was formed on first i-type amorphous silicon-based photoelectric conversion layer 12 under such conditions that the pressure in plasma CVD film deposition chamber 220 was set to 500Pa and the power density per unit electrode area of the cathode was set to 0.05W/cm² .

Thereafter, the amorphous silicon layer serving as second p-type semiconductor layer 21 and having a thickness of 10nm was formed on first n-type semiconductor layer 13 under such conditions that the pressure in plasma CVD film deposition chamber 220 was set to 500Pa and the power density per unit electrode area of the cathode was set to 0.05W/cm².

Thereafter, the amorphous silicon layer serving as second i-type amorphous silicon-based photoelectric conversion layer 52 and having a thickness of 0.3µm was formed on second p-type semiconductor layer 21 under such conditions that the pressure in plasma CVD film deposition chamber 220 was set to 500Pa and the power density per unit electrode area of the cathode was set to 0.07W/cm².

Thereafter, the amorphous silicon layer serving as second n-type semiconductor layer 23 and having a thickness of 30nm was formed on second i-type amorphous silicon-based photoelectric conversion layer 52 under such conditions that the pressure in plasma CVD film deposition chamber 220 was set to 500Pa and the power density per unit electrode area of the cathode was set to 0.05W/cm². Double pin structure stack body 30 was thus formed.

Thereafter, the ZnO layer serving as conductive film 3 and having a thickness of 0.05µm and the Ag electrode serving as metal electrode 4 and having a thickness of 0.1 µm were formed with sputtering, to manufacture the tandem-type silicon thin-film photoelectric conversion device which is the stack-type silicon thin-film photoelectric conversion device.

The photoelectric conversion efficiency of the obtained tandem-type silicon thin-film photoelectric conversion device was measured and the result was 10.9%.

Thereafter, second double pin structure stack body 60 was formed in identical plasma CVD film deposition chamber 220 under the conditions the same as above, to manufacture the stack-type silicon thin-film photoelectric conversion device with the similar method. The photoelectric conversion efficiency of the obtained second tandem-type silicon thin-film photoelectric conversion device was measured and the result was 11.0%. Thus, ten stack-type silicon thin-film photoelectric conversion devices were successively manufactured. The photoelectric conversion efficiencies of the third, fourth, fifth, sixth, seventh, eighth, ninth, and tenth tandem-type silicon thin-film photoelectric conversion devices were 10.9%, 10.9%, 11.1 %, 11.0%, 10.9%, 11.0%, 11.0%, and 11.0%, respectively. The results are shown in Fig. 11.

As can clearly be seen also from Fig. 11, no significant change in the photoelectric conversion efficiency of the first to tenth tandem-type photoelectric conversion devices was observed, and the stack-type silicon thin-film photoelectric conversion device having excellent characteristics could be manufactured in a stable manner.

It should be understood that the embodiments and the examples disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

According to the present invention, a silicon-based thin-film photoelectric conversion device with excellent performance can readily be manufactured at low cost and high efficiency.

## Claims

1. A method of manufacturing a stack-type silicon-based thin-film photoelectric conversion device, comprising the steps of:
forming a transparent conductive film (2) on a substrate (1); and
forming a double pin structure stack body (30) by successively forming a first p-type semiconductor layer (11), an i-type amorphous silicon-based photoelectric conversion layer (12), a first n-type semiconductor layer (13), a second p-type semiconductor layer (21), an i-type microcrystalline silicon-based photoelectric conversion layer (22), and a second n-type semiconductor layer (23) on said transparent conductive film (2);
said step of forming said double pin structure stack body (30) being performed in an identical plasma CVD film deposition chamber (220), and
said first p-type semiconductor layer (11), said i-type amorphous silicon-based photoelectric conversion layer (12) and said first n-type semiconductor layer (13) being formed under such conditions that a film deposition pressure in said plasma CVD film deposition chamber (220) is not lower than 200Pa and not higher than 3000Pa and power density per unit electrode area is not lower than 0.01 W/cm² and not higher than 0.3W/cm².

2. A method of manufacturing a stack-type silicon-based thin-film photoelectric conversion device, comprising the step of:
forming a double pin structure stack body (30) by successively forming, in an identical plasma CVD film deposition chamber (220), a first p-type semiconductor layer (11), an i-type amorphous silicon-based photoelectric conversion layer (12), a first n-type semiconductor layer (13), a second p-type semiconductor layer (21), an i-type microcrystalline silicon-based photoelectric conversion layer (22), and a second n-type semiconductor layer (23) on a transparent conductive film (2) formed on a substrate (1);
said first p-type semiconductor layer (11), said i-type amorphous silicon-based photoelectric conversion layer (12) and said first n-type semiconductor layer (13) being formed under such conditions that a film deposition pressure in said plasma CVD film deposition chamber (220) is not lower than 200Pa and not higher than 3000Pa and power density per unit electrode area is not lower than 0.01 W/cm² and not higher than 0.3W/cm².

3. The method of manufacturing a stack-type silicon-based thin-film photoelectric conversion device according to claim 1 or 2, wherein
said first p-type semiconductor layer (11) has a thickness not smaller than 2nm and not larger than 50nm, said i-type amorphous silicon-based photoelectric conversion layer (12) has a thickness not smaller than 0.1 µm and not larger than 0.5µm, and said first n-type semiconductor layer (13) has a thickness not smaller than 2nm and not larger than 50nm.

4. The method of manufacturing a stack-type silicon-based thin-film photoelectric conversion device according to claim 1 or 2, wherein
said second p-type semiconductor layer (21) has a thickness not smaller than 2nm and not larger than 50nm, said i-type microcrystalline silicon-based photoelectric conversion layer (22) has a thickness not smaller than 0.5µm and not larger than 20µm, and said second n-type semiconductor layer (23) has a thickness not smaller than 2nm and not larger than 50nm.

5. The method of manufacturing a stack-type silicon-based thin-film photoelectric conversion device according to claim 1 or 2, wherein
said second p-type semiconductor layer (23) is formed under such conditions that a temperature of an underlying base of said substrate (1) is not higher than 250°C, a raw material gas to be introduced in said plasma CVD film deposition chamber (220) includes a silane-based gas and a diluent gas containing a hydrogen gas, and a flow rate of said diluent gas is greater than that of said silane-based gas by at least 10 times.

6. The method of manufacturing a stack-type silicon-based thin-film photoelectric conversion device according to claim 1 or 2, wherein
impurity atom determining a conductivity type of said first p-type semiconductor layer (11) and said second p-type semiconductor layer (21) is boron atom or aluminum atom.

7. The method of manufacturing a stack-type silicon-based thin-film photoelectric conversion device according to claim 1 or 2, wherein
said i-type microcrystalline silicon-based photoelectric conversion layer (22) is formed under such conditions that a temperature of an underlying base of said substrate (1) is not higher than 250°C, a raw material gas to be introduced in said plasma CVD film deposition chamber includes a silane-based gas and a diluent gas, and a flow rate of the diluent gas is greater than that of the silane-based gas by at least 30 times and at most 100 times, and a peak intensity ratio I₅₂₀/I₄₈₀ of peak at 520nm⁻¹ with respect to peak at 480nm⁻¹ measured with Raman spectroscopy is not smaller than 5 and not larger than 10.

8. The method of manufacturing a stack-type silicon-based thin-film photoelectric conversion device according to claim 1 or 2, wherein
impurity atom determining a conductivity type of said first n-type semiconductor layer (13) and said second n-type semiconductor layer (23) is phosphorus atom.

9. The method of manufacturing a stack-type silicon-based thin-film photoelectric conversion device according to claim 1 or 2, wherein
said second n-type semiconductor layer (23) is formed under such conditions that a temperature of an underlying base of said substrate (1) is not higher than 250°C and content of phosphorus atoms relative to silicon atoms in a raw material gas to be introduced into said plasma CVD film deposition chamber (220) is not smaller than 0.1 atomic % and not larger than 5 atomic %.

10. The method of manufacturing a stack-type silicon-based thin-film photoelectric conversion device according to claim 1 or 2, wherein
after said double pin structure stack body (30) is formed, the stack-type silicon-based thin-film photoelectric conversion device (100) including said double pin structure stack body (30) is carried out of said plasma CVD film deposition chamber (220) and a remaining film on a cathode (222) and/or an inner surface (221) in said plasma CVD film deposition chamber (220) is removed.

11. The method of manufacturing a stack-type silicon-based thin-film photoelectric conversion device according to claim 10, wherein
said remaining film is removed by using gas plasma obtained by turning at least one gas selected from the group consisting of a hydrogen gas, an inert gas, and a fluorine-based cleaning gas into plasma.

12. The method of manufacturing a stack-type silicon-based thin-film photoelectric conversion device according to claim 10, wherein
said remaining film is removed by etching away the remaining film from a surface layer thereof as far as the first n-type layer located closest to said cathode (222) and/or said inner surface (221) and etching away the i-type layer of said remaining film located closest to said cathode (222) and/or said inner surface (221) to a depth in a range from at least 10nm in a direction of thickness to 90% or less of entire thickness of said i-type layer.

13. The method of manufacturing a stack-type silicon-based thin-film photoelectric conversion device according to claim 10, wherein
said remaining film on said cathode is removed by using gas plasma obtained by turning at least one gas selected from the group consisting of a hydrogen gas, an inert gas, and a fluorine-based cleaning gas into plasma when said remaining film on said cathode (222) in said plasma CVD film deposition chamber (220) has an accumulated thickness not smaller than 10µm and not larger than 1000µm.

14. A method of manufacturing a stack-type silicon-based thin-film photoelectric conversion device, comprising the step of further stacking at least one crystalline pin structure stack body (40) constituted of a p-type semiconductor layer (41), an i-type crystalline silicon-based photoelectric conversion layer (42) and an n-type semiconductor layer (43) on the second n-type semiconductor layer (23) of the double pin structure stack body (30) formed with the manufacturing method according to claim 1 or 2.

15. A stack-type silicon-based thin-film photoelectric conversion device manufactured with the manufacturing method according to claim 1 or 2.

16. A stack-type silicon-based thin-film photoelectric conversion device (100), comprising:
a transparent conductive film (2) formed on a substrate (1); and
a double pin structure stack body (30);
said double pin structure stack body (30) being formed of a first p-type semiconductor layer (11), an i-type amorphous silicon-based photoelectric conversion layer (12), a first n-type semiconductor layer (13), a second p-type semiconductor layer (21), an i-type microcrystalline silicon-based photoelectric conversion layer (22), and a second n-type semiconductor layer (23) successively formed on said transparent conductive film (2), and
each of said first n-type semiconductor layer (13) and said second p-type semiconductor layer (21) having an impurity nitrogen atom concentration not higher than 1 × 10¹⁹cm⁻³ and an impurity oxygen atom concentration not higher than 1×10²⁰cm⁻³.

17. A stack-type silicon-based thin-film photoelectric conversion device, comprising:
a transparent conductive film (2) formed on a substrate (1); and
a double pin structure stack body (30);
said double pin structure stack body (30) being formed of a first p-type semiconductor layer (11), an i-type amorphous silicon-based photoelectric conversion layer (12), a first n-type semiconductor layer (13), a second p-type semiconductor layer (21), an i-type microcrystalline silicon-based photoelectric conversion layer (22), and a second n-type semiconductor layer (23) successively formed on said transparent conductive film (2), and
concentration of impurity atom determining a conductivity type of said first n-type semiconductor layer (13) being not higher than 3x10¹⁹cm⁻³ and concentration of impurity atom determining a conductivity type of said second p-type semiconductor layer (21) being not higher than 5x10¹⁹cm⁻³.

18. A manufacturing apparatus used for a method of manufacturing a stack-type silicon-based thin-film photoelectric conversion device by forming a double pin structure stack body (30) by successively forming, in an identical plasma CVD film deposition chamber (220), a first p-type semiconductor layer (11), an i-type amorphous silicon-based photoelectric conversion layer (12), a first n-type semiconductor layer (13), a second p-type semiconductor layer (21), an i-type microcrystalline silicon-based photoelectric conversion layer (22), and a second n-type semiconductor layer (23) on a transparent conductive film (2) formed on a substrate (1), comprising:
the plasma CVD film deposition chamber (220) where a cathode (222) and an anode (223) are arranged;
a gas pressure regulating portion (211) regulating a gas pressure within said plasma CVD film deposition chamber (220); and
an electric power supply portion (201) supplying electric power to said cathode;
a distance between said cathode (222) and said anode (223) being not smaller than 3mm and not larger than 20mm, and
in forming said first p-type semiconductor layer (11), said i-type amorphous silicon-based photoelectric conversion layer (12) and said first n-type semiconductor layer (13), said gas pressure regulating portion (211) being capable of controlling a gas pressure within said CVD film deposition chamber (220) in a range from at least 200Pa to at most 3000Pa, and said electric power supply portion (201) being capable of controlling power density per unit area of said cathode (222) in a range from at least 0.01 W/cm² to at most 0.3 W/cm².

19. A method of manufacturing a silicon-based thin-film photoelectric conversion device, comprising the step of:
forming an amorphous pin structure stack body (10) by successively forming, in an identical plasma CVD film deposition chamber (220), a p-type semiconductor layer (11), an i-type amorphous silicon-based photoelectric conversion layer (12), and an n-type semiconductor layer (13) on a transparent conductive film (2) formed on a substrate (1);
said p-type semiconductor layer (11), said i-type amorphous silicon-based photoelectric conversion layer (12) and said n-type semiconductor layer (13) being formed under such conditions that a film deposition pressure in said plasma CVD film deposition chamber (220) is not lower than 200Pa and not higher than 3000Pa and power density per unit electrode area is not lower than 0.01 W/cm² and not higher than 0.3 W/cm².

20. The method of manufacturing a silicon-based thin-film photoelectric conversion device according to claim 19, wherein
after said amorphous pin structure stack body (10) is formed, the silicon-based thin-film photoelectric conversion device (500) including said amorphous pin structure stack body (10) is carried out of said plasma CVD film deposition chamber (220) and a remaining film on a cathode (222) and/or an inner surface (221) in said plasma CVD film deposition chamber (220) is removed.

21. A silicon-based thin-film photoelectric conversion device manufactured with the manufacturing method according to claim 19.

22. A manufacturing apparatus used for a method of manufacturing a silicon-based thin-film photoelectric conversion device by forming an amorphous pin structure stack body (10) by successively forming, in an identical plasma CVD film deposition chamber (220), a p-type semiconductor layer (11), an i-type amorphous silicon-based photoelectric conversion layer (12), and an n-type semiconductor layer (13) on a transparent conductive film (2) formed on a substrate (1), comprising:
the plasma CVD film deposition chamber (220) where a cathode (222) and an anode (223) are arranged;
a gas pressure regulating portion (211) regulating a gas pressure within said plasma CVD film deposition chamber (220); and
an electric power supply portion (201) supplying electric power to said cathode (222);
a distance between said cathode (222) and said anode (223) being not smaller than 3mm and not larger than 20mm, and
in forming said p-type semiconductor layer (11), said i-type amorphous silicon-based photoelectric conversion layer (12) and said n-type semiconductor layer (13), said gas pressure regulating portion (211) being capable of controlling a gas pressure within said CVD film deposition chamber (220) in a range from at least 200Pa to at most 3000Pa, and said electric power supply portion (201) being capable of controlling power density per unit area of said cathode (222) in a range from at least 0.01 W/cm² to at most 0.3W/cm².

23. A method of manufacturing a stack-type silicon-based thin-film photoelectric conversion device, comprising the step of:
forming a double pin structure stack body (60) by successively forming, in an identical plasma CVD film deposition chamber (220), a first p-type semiconductor layer (11), a first i-type amorphous silicon-based photoelectric conversion layer (12), a first n-type semiconductor layer (13), a second p-type semiconductor layer (21), a second i-type amorphous silicon-based photoelectric conversion layer (52), and a second n-type semiconductor layer (23) on a transparent conductive film (2) formed on a substrate (1);
said first p-type semiconductor layer (11), said first i-type amorphous silicon-based photoelectric conversion layer (12), said first n-type semiconductor layer (13), said second p-type semiconductor layer (21), said second i-type amorphous silicon-based photoelectric conversion layer (52), and said second n-type semiconductor layer (23) being formed under such conditions that a film deposition pressure in said plasma CVD film deposition chamber (220) is not lower than 200Pa and not higher than 3000Pa and power density per unit electrode area is not lower than 0.01 W/cm² and not higher than 0.3W/cm².

24. The method of manufacturing a stack-type silicon-based thin-film photoelectric conversion device according to claim 23, wherein
after said double pin structure stack body (60) is formed, the stack-type silicon-based thin-film photoelectric conversion device (600) including said double pin structure stack body (60) is carried out of said plasma CVD film deposition chamber (220) and a remaining film on a cathode (222) and/or an inner surface (221) in said plasma CVD film deposition chamber (220) is removed.

25. A stack-type silicon-based thin-film photoelectric conversion device manufactured with the manufacturing method according to claim 23.

26. A manufacturing apparatus used for a method of manufacturing a stack-type silicon-based thin-film photoelectric conversion device by forming a double pin structure stack body (60) by successively forming, in an identical plasma CVD film deposition chamber (220), a first p-type semiconductor layer (11), a first i-type amorphous silicon-based photoelectric conversion layer (12), a first n-type semiconductor layer (13), a second p-type semiconductor layer (21), a second i-type amorphous silicon-based photoelectric conversion layer (52), and a second n-type semiconductor layer (23) on a transparent conductive film (2) formed on a substrate (1), comprising:
the plasma CVD film deposition chamber (220) where a cathode (222) and an anode (223) are arranged;
a gas pressure regulating portion (211) regulating a gas pressure within said plasma CVD film deposition chamber (220); and
an electric power supply portion (201) supplying electric power to said cathode (222);
a distance between said cathode (222) and said anode (223) being not smaller than 3mm and not larger than 20mm, and
in forming said first p-type semiconductor layer (11), said first i-type amorphous silicon-based photoelectric conversion layer (12), said first n-type semiconductor layer (13), said second p-type semiconductor layer (21), said second i-type amorphous silicon-based photoelectric conversion layer (52), and said second n-type semiconductor layer (23), said gas pressure regulating portion (211) being capable of controlling a gas pressure within said CVD film deposition chamber (220) in a range from at least 200Pa to at most 3000Pa, and said electric power supply portion (201) being capable of controlling power density per unit area of said cathode (222) in a range from at least 0.01 W/cm² to at most 0.3 W/cm².
